# EUROPEAN PATENT APPLICATION

(11) **EP 4 596 652 A1**
(43) Date of publication of application: **06.08.2025**
(21) Application number: 25155213.9
(22) Date of filing: 31.01.2025
(51) Int. Cl.: C09K 11/02, C09K 11/56, C09K 11/88

(54) **SEMICONDUCTOR NANOPARTICLE, PRODUCTION METHOD THEREOF, ELECTROLUMINESCENT DEVICE, AND DISPLAY DEVICE INCLUDING THE SAME**

(30) Priority: 02.02.2024 KR 20240016847
(71) Applicant: Samsung Electronics Co., Ltd., Suwon-si, Gyeonggi-do 16677 (KR)
(72) Inventor: HA, Hyundong, 16678 Suwon-si (KR); KIM, Kwang Hee, 16678 Suwon-si (KR); MIN, Ji Hyun, 16678 Suwon-si (KR); YOON, Daeun, 16678 Suwon-si (KR); YOON, Won Sik, 16678 Suwon-si (KR); LEE, Jae Yong, 16678 Suwon-si (KR); CHANG, Hogeun, 16678 Suwon-si (KR)
(74) Representative: Elkington and Fife LLP

(57) **Abstract**

A semiconductor nanoparticle, a production method, and an electroluminescent device including the same. The semiconductor nanoparticle includes zinc, sulfur, and selenium, and the semiconductor nanoparticle comprises a first semiconductor nanocrystal; and a semiconductor nanocrystal shell including zinc and sulfur disposed on the first semiconductor nanocrystal, and the semiconductor nanoparticle does not include cadmium; the semiconductor nanoparticle further includes a plurality of organic ligands (or a ligand system), that include a first organic ligand having a carboxylate moiety and a second organic ligand having a carboxylate moiety different from the first organic ligand. In a gas chromatography analysis, the semiconductor nanoparticle exhibits a first peak assigned to the first organic ligand and a second peak assigned to the second organic ligand, wherein an area percentage of the first peak relative to the second peak is greater than or equal to about 1 % and less than or equal to about 300%.

## Description

### FIELD OF THE INVENTION

The present disclosure relates to semiconductor nanoparticles, methods of producing the semiconductor nanoparticles, and a device including the semiconductor nanoparticles, including an electroluminescent device and a display device.

### BACKGROUND OF THE INVENTION

A semiconductor nanoparticle (e.g., semiconductor nanocrystal particle) may emit light. For example, a quantum dot including a semiconductor nanocrystal may exhibit a quantum confinement effect, exhibiting luminous properties. Light emission of the semiconductor nanoparticle may occur, for instance, when an excited electron, either by light excitation or by application of a voltage, make transitions from a conduction band to a valence band. The semiconductor nanoparticle may be configured to emit light of a desired wavelength region by controlling a size, composition, or a combination thereof.

A nanoparticle may be used in a light emitting device (e.g., an electroluminescent device) and a display device including the nanoparticle.

### SUMMARY OF THE INVENTION

An embodiment provides a semiconductor nanoparticle that can exhibit an improved property (e.g., electroluminescent properties and a longer device lifetime).

An embodiment relates to a method for manufacturing the semiconductor nanoparticle.

An embodiment provides a light emitting device for example, capable of emitting light, for example, by applying a voltage to a semiconductor nanoparticle (e.g., a quantum dot).

An embodiment provides a display device (e.g., a quantum dot light emitting diode ("QD-LED") display) including the nanoparticle as a light emitting material in a blue pixel, a red pixel, a green pixel, or a combination thereof.

According to an embodiment, the semiconductor nanoparticle includes: zinc, selenium, and sulfur, and wherein the semiconductor nanoparticle does not comprise cadmium; wherein the semiconductor nanoparticle includes a first semiconductor nanocrystal and a semiconductor nanocrystal shell including zinc and sulfur disposed on the first semiconductor nanocrystal; the semiconductor nanoparticle further includes a plurality of organic ligands (or a ligand system including the same), and the plurality of organic ligands includes a first organic ligand having a carboxylate moiety and a second organic ligand different from the first organic ligand and having a carboxylate moiety; wherein in a gas chromatography (GC) analysis, the semiconductor nanoparticle exhibits a first peak assigned to the first organic ligand and a second peak assigned to the second organic ligand, wherein an area percentage of the first peak relative to the second peak is greater than or equal to about 1%, or greater than or equal to about 3% and less than or equal to about 300%.

The area percentage of the first peak relative to the second peak may be greater than or equal to about 5% and less than or equal to about 150%.

The area percentage of the first peak relative to the second peak may be less than or equal to about 99%, or less than or equal to about 80%.

The area percentage of the first peak relative to the second peak may be greater than or equal to about 70%, greater than or equal to about 95%, or greater than or equal to about 100%.

The second organic ligand may have a higher molecular weight than the first organic ligand.

The second organic ligand may have a carbon number of greater than or equal to about 15, greater than or equal to about 16, or greater than or equal to about 17.

A ratio of a retention time (minutes) of the first peak to a retention time (minutes) of the second peak may be greater than or equal to about 0.1:1, greater than or equal to about 0.5:1, or greater than or equal to about 0.7:1 and less than or equal to about 1:1, or less than or equal to about 0.9:1. The retention time of the second peak may be longer than the retention time of the first peak. A difference in the retention time between the second peak and the first peak may be greater than or equal to about 2 minutes, or greater than or equal to about 5 minutes. The difference in the retention time between the second peak and the first peak may be less than or equal to about 12 minutes, or less than or equal to about 10 minutes.

The semiconductor nanoparticle may further include a halogen. The halogen may be fluorine, chlorine, bromine, iodine, or a combination thereof. In an embodiment, the halogen may be chlorine.

In the semiconductor nanoparticle, a mole ratio of halogen to zinc may be greater than or equal to about 0.01:1, greater than or equal to about 0.05:1, greater than or equal to about 0.1:1, greater than or equal to about 0.15:1, or greater than or equal to about 0.2:1. In the semiconductor nanoparticle, the mole ratio of halogen to zinc may be less than or equal to about 1:1, less than or equal to about 0.9:1, less than or equal to about 0.7:1, or less than or equal to about 0.5:1.

The semiconductor nanoparticle, the first semiconductor nanocrystal, or the semiconductor nanocrystal shell may include a Group II-VI compound, a Group III-V compound, a Group IV-VI compound, a Group IV element or compound, a Group II-III-VI compound, a Group I-III-VI compound, a Group I-II-IV-VI compound, or a combination thereof.

The semiconductor nanoparticle or the first semiconductor nanocrystal may include an indium phosphide, an indium zinc phosphide, a zinc selenide, a zinc telluride, a zinc tellurium selenide, a silver indium gallium sulfide, a silver indium sulfide, or a combination thereof. The semiconductor nanoparticle or the semiconductor nanocrystal shell may include a zinc selenide, a zinc selenide telluride, a zinc selenide sulfide, a zinc sulfide, or a combination thereof. The semiconductor nanocrystal shell may include a first shell layer; and a second shell layer disposed on the first shell layer. The first shell layer may include a zinc selenide, a zinc selenide telluride, a zinc selenide sulfide, or a combination thereof. The second shell layer may include a zinc selenide sulfide, a zinc sulfide, or a combination thereof. The semiconductor nanoparticle may not include lead. The semiconductor nanoparticle may not include copper.

The semiconductor nanoparticle may be configured to emit a first light.

The first light may have a red light spectrum, a green light spectrum, or a blue light spectrum. The first light may have a full width at half maximum (FWHM) of greater than or equal to about 1 nm and less than or equal to about 55 nanometers (nm).

The first light may be blue light. The emission peak wavelength of the first light or the blue light may be greater than or equal to about 440 nm and less than or equal to about 480 nm.

The first light may be green light. The emission peak wavelength of the first light or the green light may be greater than or equal to about 500 nm and less than or equal to about 580 nm.

The first light may be red light. The emission peak wavelength of the first light or the red light may be greater than or equal to about 600 nm and less than or equal to about 680 nm.

The organic ligands or the ligand system may be bound or disposed on the surface of the semiconductor nanocrystal.

The total number of carbon atoms in the organic ligand or the ligand system may be greater than or equal to about 20, greater than or equal to about 22, greater than or equal to about 24, greater than or equal to about 28, or greater than or equal to about 29. The total number of carbon atoms may be less than or equal to about 34, less than or equal to about 32, less than or equal to about 30, less than or equal to about 28, or less than or equal to about 27.

The first organic ligand may have a molecular weight of greater than or equal to about 90 grams per mole (g/mol), or greater than or equal to about 100 g/mol and less than or equal to about 260 g/mol, less than or equal to about 230 g/mol, less than or equal to about 210 g/mol, less than or equal to about 205 g/mol, less than or equal to about 200 g/mol, or less than or equal to about 170 g/mol.

The second organic ligand may have a molecular weight of greater than about 200 g/mol, greater than or equal to about 225 g/mol, greater than or equal to about 250 g/mol, or greater than or equal to about 280 g/mol, and less than or equal to about 500 g/mol, or less than or equal to about 250 g/mol.

The first organic ligand may include a substituted or unsubstituted C6-C12 aromatic hydrocarbon group, a substituted or unsubstituted C3-C12 or C5-C9 or C4-C8 or C6-C7 linear or branched aliphatic hydrocarbon group (e.g., an alkyl group, an alkenyl group, or an alkynyl group), or a combination thereof.

The first organic ligand may include a hexanoate moiety substituted with a C1-C3 alkyl group, a butanoate moiety substituted with a C1-C3 alkyl group, a pentanoate moiety substituted with a C1-C3 alkyl group, an octanoate moiety substituted with a C1-C4 alkyl group, or a combination thereof. The first organic ligand may include a hexanoate group, a methylbutanoate group, a butyloctanoate group, or a combination thereof.

The second organic ligand may include a C13-C25, C14-C23, C15-C22, C16-C21, C17-C20, or C18-C19 linear or branched aliphatic hydrocarbon group (e.g., an alkyl group, an alkenyl group, or an alkynyl group). The second organic ligand may include an aliphatic hydrocarbon group of C17 or greater.

The second organic ligand may include at least one, or at least two, carbon-carbon double bond(s), for example, as a terminal group or within the aliphatic hydrocarbon group chain.

The first organic ligand may include a branched alkyl group, and the second organic ligand may include a linear alkenyl group.

The area percentage of the first peak relative to the second peak may be greater than or equal to about 10%, greater than or equal to about 30%, or greater than or equal to about 40%. The area percentage of the first peak relative to the second peak may be less than or equal to about 90%, less than or equal to about 80%, or less than or equal to about 75%.

The semiconductor nanoparticle may not substantially exhibit a peak assigned to a thiol in the gas chromatogram. The area ratio of the peak assigned to a thiol relative to the second peak in the gas chromatogram may be less than or equal to about 10%, less than or equal to about 5%, less than or equal to about 2%, or less than or equal to about 1%.

The semiconductor nanoparticles may have a particle size or average particle size (hereinafter, simply referred to as "particle size") of greater than or equal to about 8 nm, greater than or equal to about 10 nm, or greater than or equal to about 12 nm, and less than or equal to about 50 nm, or less than or equal to about 45 nm.

In a thermogravimetric analysis, the semiconductor nanoparticle may have a weight loss (e.g., an organic content) in the range of 200°C to 550°C that is less than or equal to about 13%, less than or equal to about 11.5%, less than or equal to about 11 %, or less than or equal to about 8% of a total weight of the semiconductor nanoparticle. In the thermogravimetric analysis, the semiconductor nanoparticle may have a weight loss in the range of 200°C to 550°C that is greater than or equal to about 3% of the total weight of the semiconductor nanoparticle.

In the thermogravimetric analysis, the semiconductor nanoparticle may exhibit a residual content that is greater than or equal to about 550°C of greater than or equal to about 82%, greater than or equal to about 87%, greater than or equal to about 88%, or greater than or equal to about 89%, and less than or equal to about 99%, less than or equal to about 93%, or less than or equal to about 91% of a total weight of the semiconductor nanoparticle.

In a dynamic light scattering analysis (DLS), the semiconductor nanoparticle may exhibit a DLS particle diameter of less than about 300 nm. The DLS particle diameter may be less than or equal to about 200 nm, less than or equal to about 100 nm, or less than or equal to about 50 nm. The DLS particle diameter may be greater than or equal to about 10 nm, or greater than or equal to about 15 nm.

The semiconductor nanoparticles, in time-resolved photoluminescence spectroscopy, may have an average lifetime (or average decay time) of greater than or equal to about 20 nanoseconds (ns), greater than or equal to about 30 ns, greater than or equal to about 40 ns, or greater than or equal to about 50 ns.

The semiconductor nanoparticles, in time-resolved photoluminescence spectroscopy, may have an average lifetime (or average decay time) of less than or equal to about 500 ns, less than or equal to about 300 ns, less than or equal to about 100 ns, or less than or equal to about 80 ns.

In an embodiment, a method for producing the semiconductor nanoparticle includes:
contacting (e.g., reacting) a zinc precursor and a sulfur precursor in a reaction medium including an organic solvent and optionally an organic ligand, in the presence of a particles including a first semiconductor nanocrystal and optionally a second semiconductor nanocrystal; and
adding a metal halide to the reaction medium,
wherein the zinc precursor includes a first zinc precursor including a first organic ligand and a zinc ion, and a second zinc precursor including a second organic ligand and a zinc ion.

Details of the first semiconductor nanocrystal, the first organic ligand, and the second organic ligand are as described herein.

In an embodiment of the method, the first semiconductor nanocrystal may include or may not include zinc, selenium, or a combination thereof. In an embodiment of the method, if present, the second semiconductor nanocrystal may include zinc and selenium.

In an embodiment of the method, the first zinc precursor may contact the sulfur precursor first, followed by the second zinc precursor contacting the sulfur precursor. In the method of an embodiment, the second zinc precursor may contact the sulfur precursor first, followed by the first zinc precursor contacting the sulfur precursor.

In an embodiment of the method, the metal halide may be added after the first zinc precursor or the second zinc precursor has contacted the sulfur precursor.

In an embodiment of the method, the first zinc precursor may contact the sulfur precursor first, followed by the second zinc precursor contacting the sulfur precursor, and the second zinc precursor may be added and admixed to the reaction medium simultaneously with or after the addition of the metal halide.

In an embodiment of the method, the second zinc precursor may contact the sulfur precursor first, followed by the first zinc precursor contacting the sulfur precursor, and the first zinc precursor may be added and admixed to the reaction medium simultaneously with or after the addition of the metal halide.

In an embodiment of the method, an amount of the second zinc precursor per 1 mole of the first zinc precursor may be greater than or equal to about 0.01 moles, greater than or equal to about 0.05 moles, greater than or equal to about 0.1 moles, greater than or equal to about 0.5 moles, greater than or equal to about 1 mole, greater than or equal to about 5 moles, greater than or equal to about 10 moles, greater than or equal to about 50 moles, or greater than or equal to about 100 moles.

In an embodiment of the method, the amount of the second zinc precursor per 1 mole of the first zinc precursor may be less than or equal to about 100 moles, less than or equal to about 70 moles, less than or equal to about 40 moles, less than or equal to about 10 moles, less than or equal to about 3 moles, less than or equal to about 1 mole, less than or equal to about 0.4 moles, less than or equal to about 0.2 moles, less than or equal to about 0.06 moles, or less than or equal to about 0.03 moles.

In an embodiment of the method, an amount of the metal halide per one mole of the zinc precursor may be greater than or equal to about 0.01 moles, greater than or equal to about 0.05 moles, greater than or equal to about 0.1 moles, greater than or equal to about 0.5 moles, greater than or equal to about 1 mole, greater than or equal to about 5 moles, greater than or equal to about 10 moles, greater than or equal to about 50 moles, or greater than or equal to about 100 moles.

In an embodiment of the method, the amount of the metal halide per one mole of the zinc precursor may be less than or equal to about 100 moles, less than or equal to about 70 moles, less than or equal to about 40 moles, less than or equal to about 10 moles, less than or equal to about 3 moles, less than or equal to about 1 mole, less than or equal to about 0.4 moles, less than or equal to about 0.2 moles, less than or equal to about 0.06 moles, or less than or equal to about 0.03 moles.

In an embodiment, an electroluminescent device includes a first electrode and a second electrode, for example, spaced apart from each other, and a light-emitting layer disposed between the first electrode and the second electrode, wherein the light-emitting layer includes the above-described semiconductor nanoparticle.

Details of the semiconductor nanoparticle are as described herein.

The light-emitting layer may be configured to emit a first light upon application of a voltage.

Details of the first light are as described herein. In an embodiment, a luminescence (e.g., electro or photo luminescence) peak wavelength of the first light or the semiconductor nanoparticle may be greater than or equal to about 440 nm, or greater than or equal to about 460 nm, and less than or equal to about 480 nm, or less than or equal to about 470 nm.

In an embodiment, the peak emission wavelength (e.g., electroluminescent peak wavelength) of the first light or the semiconductor nanoparticle may be greater than or equal to about 500 nm, or greater than or equal to about 510 nm, and less than or equal to about 580 nm, or less than or equal to about 540 nm. In an embodiment, the peak emission wavelength of the first light or the semiconductor nanoparticle may be greater than or equal to about 600 nm, or greater than or equal to about 610 nm, and less than or equal to about 680 nm, or less than or equal to about 635 nm.

The first electrode may be an anode and the second electrode may be a cathode.

The electroluminescent device may further include a charge auxiliary layer between the light-emitting layer and the first electrode, between the light-emitting layer and the second electrode, or both.

The electroluminescent device may further include a hole auxiliary layer between the light-emitting layer and the first electrode. The electroluminescent device may further include an electron auxiliary layer between the light-emitting layer and the second electrode.

The charge auxiliary layer may include a hole auxiliary layer including an organic compound, an electron auxiliary layer including metal oxide nanoparticles, or a combination thereof.

The electroluminescent device may have a maximum luminance of greater than or equal to about 80,000 candela per square meter (cd/m²), greater than or equal to about 90,000 cd/m², or greater than or equal to about 100,000 cd/m².

The electroluminescent device may have a maximum external quantum efficiency of greater than or equal to about 9%, greater than or equal to about 10%, or greater than or equal to about 11%.

The electroluminescent device may have a time (hour, hr) taken until the initial brightness (e.g., luminance) of a given device decreases to 90% (T90) of greater than or equal to about 1,000 hours (e.g., when measured at an initial luminance of 146 nits).

An embodiment relates to an electronic device or display device comprising the electroluminescent device.

The display device or electronic device may include a virtual reality display device, an augmented reality display device, a mobile terminal device, a monitor, a notebook, a television, a signboard, a camera, or an automotive component, or the like.

According to an embodiment, the semiconductor nanoparticle may exhibit improved optical properties and lifespan characteristics, e.g., a longer lifespan, when applied to an electroluminescent device, and may exhibit suitable dispersion properties for providing as an ink composition.

### BRIEF DESCRIPTION OF THE DRAWINGS

The above and other advantages and features of this disclosure will become more apparent by describing in further detail exemplary embodiments thereof with reference to the accompanying drawings, in which:
FIG. 1 is a schematic cross-sectional view of an embodiment of a quantum dot light emitting diode ("QD-LED") device;
FIG. 2 is a schematic cross-sectional view of an embodiment of a QD-LED device; and
FIG. 3 is a schematic cross-sectional view of an embodiment of a QD-LED device.
FIG. 4 is a schematic cross-sectional view of a QD LED device according to an embodiment.
FIG. 5 is a schematic cross-sectional view of a light emitting device (RGB pixel) according to an embodiment.
FIG. 6 is a schematic front view of a display panel according to an embodiment.
FIG. 7 is a schematic cross-sectional view of the display panel of FIG. 6 taken along line IV-IV.
FIG. 8 shows the results of gas chromatography analysis illustrating intensity (Counts, %) versus Acquisition Time (i.e., retention time, RT) (minutes, min) of the semiconductor nanoparticles synthesized in Preparation Examples 1-3 and 6-7.

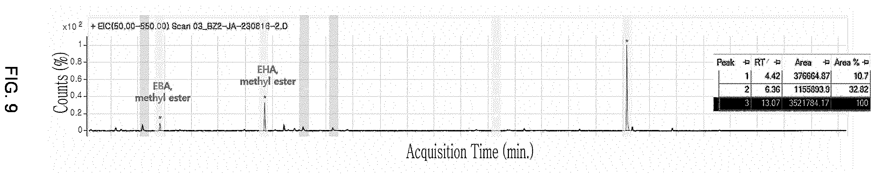

FIG. 9 shows the results of gas chromatography analysis illustrating intensity (Counts, %) versus Acquisition Time (i.e., retention time, RT)(minutes, min) of the semiconductor nanoparticle synthesized in Preparation Example 4.

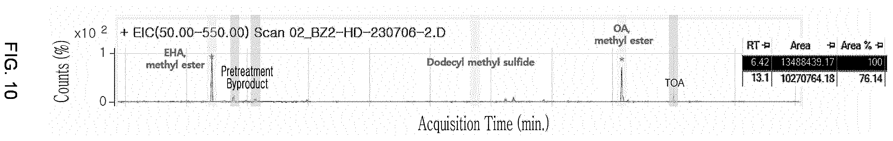

FIG. 10 shows the results of gas chromatography analysis illustrating intensity (Counts, %) versus Acquisition Time (i.e., retention time, RT) (minutes, min) of the semiconductor nanoparticle synthesized in Preparation Example 5.

### DETAILED DESCRIPTION

Advantages and characteristics of this disclosure, and a method for achieving the same, will become evident referring to the following exemplary embodiments together with the drawings attached hereto. However, this invention may be embodied in many different forms, the embodiments should not be construed as being limited to the embodiments set forth herein. Rather, these embodiments are provided so that this disclosure will be thorough and complete, and will fully convey the scope of the invention to those skilled in the art. Like reference numerals refer to like elements throughout.

In order to clearly explain the present disclosure, parts irrelevant to the description are omitted, and the same reference numerals are assigned to the same or similar elements throughout the specification. In the drawings, the thickness of layers, films, panels, regions, etc., are exaggerated for clarity. And in the drawings, for convenience of description, the thickness of some layers and regions are exaggerated. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

In addition, it will be understood that when an element such as a layer, film, region, or substrate is referred to as being "on" another element, it may be directly on the other element or intervening elements may also be present. In contrast, when an element is referred to as being "directly on" another element, there are no intervening elements present. Also, to be disposed "on" the reference portion means to be disposed above or below the reference portion and does not necessarily mean "above".

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

It will be understood that, although the terms "first," "second," "third," etc., may be used herein to describe various elements, components, regions, layers and/or sections, these elements, components, regions, layers and/or sections should not be limited by these terms. These terms are only used to distinguish one element, component, region, layer or section from another element, component, region, layer, or section. Thus, "a first element," "component," "region," "layer," or "section" discussed below could be termed a second element, component, region, layer, or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as being limited to "a" or "an." "Or" means "and/or."

As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

As used herein, the term "cross-sectional" means a case in which a cross-section of a given object is cut, for example, in a substantially vertical direction and is viewed laterally.

Unless otherwise defined, all terms (including technical and scientific terms) used herein have the same meaning as commonly understood by one of ordinary skill in the art to which this disclosure belongs. It will be further understood that terms, such as those defined in commonly used, e.g., non-technical, dictionaries, should be interpreted as having a meaning that is consistent with their meaning in the context of the relevant art and the present disclosure, and will not be interpreted in an idealized or overly formal sense unless expressly so defined herein.

As used herein, values of a work function, a conduction band, or a lowest unoccupied molecular orbital (LUMO) (or valence band, or highest occupied molecular orbital (HOMO)) energy level is expressed as an absolute value from a vacuum level. In addition, when the work function or the energy level is referred to be "deep," "high" or "large," the work function or the energy level has a large absolute value based on "0 electron volt (eV)" of the vacuum level, while when the work function or the energy level is referred to be "shallow," "low," or "small," the work function or energy level has a small absolute value based on "0 electron volt (eV)" of the vacuum level. In an aspect, work function herein refers to a minimum energy required to remove an electron from e.g., a solid metal (e.g., a metal surface) to vacuum (e.g., immediately outside the solid surface).

As used herein, the term "first absorption peak" refers to a main excitonic peak appearing first from the longest wavelength region of a ultraviolet-visual (UV-Vis) absorption spectrum (i.e., appearing in the lowest energy region in the UV-Vis absorption spectrum), and the term "first absorption peak wavelength" or "wavelength of the first absorption peak" refers to the wavelength at which the first absorption peak reaches a maximum intensity.

As used herein, the average (value) may be mean or median. In an embodiment, the average (value) may be a mean value.

As used herein, the term "peak emission wavelength" is the wavelength at which a given emission spectrum of the light reaches its maximum.

As used herein, the term "Group" may refer to a group of Periodic Table.

As used herein, "Group I" refers to Group IA and Group IB, and examples may include Li, Na, K, Rb, and Cs, but are not limited thereto.

As used herein, "Group II" refers to Group IIA and Group IIB, and examples of Group II metal may be Cd, Zn, Hg, and Mg, but are not limited thereto.

As used herein, "Group III" refers to Group IIIA and Group IIIB, and examples of Group IIIA metal may be Al, In, Ga, and Tl, and examples of Group IIIB may be scandium, yttrium, or the like, but are not limited thereto.

As used herein, "Group IV" refers to Group IVA and Group IVB, and examples of a Group IVA metal may be Si, Ge, and Sn, and examples of Group IVB metal may be titanium, zirconium, hafnium, or the like, but are not limited thereto.

As used herein, "Group V" includes Group VA and includes nitrogen, phosphorus, arsenic, antimony, and bismuth, but is not limited thereto.

As used herein, "Group VI" includes Group VIA and includes sulfur, selenium, and tellurium, but is not limited thereto.

As used herein, "metal" includes a semi-metal such as Si.

As used herein, a number of carbon atoms in a group or a molecule may be referred to as a subscript (e.g., C₆₋₅₀) or as C6-C50.

As used herein, when a definition is not otherwise provided, "substituted" refers to replacement of at least one hydrogen of a compound or a group with a corresponding substituent including a C1-C30 alkyl group, a C2-C30 alkenyl group, a C2-C30 alkynyl group, a C6-C30 aryl group, a C7-C30 alkylaryl group, a C1-C30 alkoxy group, a C1-C30 heteroalkyl group, a C3-C30 heteroaryl group, a C3-C30 cycloalkyl group, a C3-C15 cycloalkenyl group, a C6-C30 cycloalkynyl group, a C2-C30 heterocycloalkyl group, a halogen (-F, -Cl, -Br, or -I), a hydroxy group (-OH), a nitro group (-NO₂), a cyano group (-CN), an amino group (-NRR' wherein R and R' are each independently hydrogen or a C1-C6 alkyl group), an azido group (-N₃), an amidino group (-C(=NH)NH₂), a hydrazino group (-NHNH₂), a hydrazono group (=N(NH₂)), an aldehyde group (-C(=O)H), a carbamoyl group (-C(O)NH₂), a thiol group (-SH), an ester group (-C(=O)OR, wherein R is a C1-C6 alkyl group or a C6-C12 aryl group), a carboxyl group (-COOH) or a salt thereof (-C(=O)OM, wherein M is an organic or inorganic cation), a sulfonic acid group (-SOsH) or a salt thereof (-SOsM, wherein M is an organic or inorganic cation), a phosphoric acid group (-PO₃H₂) or a salt thereof (-POsMH or -PO₃M₂, wherein M is an organic or inorganic cation), or a combination thereof.

As used herein, when a definition is not otherwise provided, "hydrocarbon" or "hydrocarbon group" refers to a compound or a group including carbon and hydrogen (e.g., alkyl, alkenyl, alkynyl, or aryl group). The hydrocarbon group may be a monovalent group or a group having a valence of greater than one formed by removal of one or more hydrogen atoms from an alkane, an alkene, an alkyne, or an arene group. In the hydrocarbon or hydrocarbon group, at least one, methylene may be replaced by an oxide moiety, a carbonyl moiety, an ester moiety, -NH-, or a combination thereof. Unless otherwise stated to the contrary, the hydrocarbon or the hydrocarbon group (alkyl, alkenyl, alkynyl, or aryl) may have 1 to 60, 2 to 32, 3 to 24, or 4 to 12 carbon atoms.

As used herein, when a definition is not otherwise provided, "alkyl" refers to a linear or branched saturated monovalent hydrocarbon group (methyl, ethyl hexyl, etc.). In an embodiment, an alkyl group may have from 1 to 50 carbon atoms, or 1 to 18 carbon atoms, or 1 to 12 carbon atoms.

As used herein, when a definition is not otherwise provided, "alkenyl" refers to a linear or branched monovalent hydrocarbon group having a carbon-carbon double bond. In an embodiment, an alkenyl group may have from 2 to 50 carbon atoms, or 2 to 18 carbon atoms, or 2 to 12 carbon atoms.

As used herein, when a definition is not otherwise provided, "alkynyl" refers to a linear or branched monovalent hydrocarbon group having a carbon-carbon triple bond. In an embodiment, an alkenyl group may have from 2 to 50 carbon atoms, or 2 to 18 carbon atoms, or 2 to 12 carbon atoms.

As used herein, when a definition is not otherwise provided, "aryl" refers to a group having a carbocyclic aromatic system. When the aryl group includes a plurality of rings, the plurality of rings may be fused to each other. Examples include a phenyl group and a naphthyl group. In an embodiment, an aryl group may have 6 to 50 carbon atoms, or 6 to 18 carbon atoms, or 6 to 12 carbon atoms.

As used herein, when a definition is not otherwise provided, "hetero" refers to inclusion of 1 to 3 heteroatoms, e.g., N, O, P, Si, B, Se, Ge, Te, S, or a combination thereof.

As used herein, "heteroaryl" refers to an aromatic system having at least one N, O, P, Si, B, Se, Ge, Te, S, or a combination thereof as a ring forming atom. Examples of heteroaryl groups include a pyridinyl group, a pyrimidinyl group, a pyrazinyl group, a pyridazinyl group, a triazinyl group, a quinolinyl group, and an isoquinolinyl group. When the heteroaryl group includes a plurality of rings, the plurality of rings may be fused to each other. In an embodiment, the heteroaryl group may have 3 to 50 carbon atoms, or 6 to 18 carbon atoms, or 6 to 12 carbon atoms.

As used herein, when a definition is not otherwise provided, "alkoxy" refers to an alkyl group linked to oxygen (e.g., alkyl-O-) for example, a methoxy group, an ethoxy group, or a sec-butyloxy group.

The term "cycloalkyl group" as used herein refers to a monovalent monocyclic saturated hydrocarbon group. Examples thereof include a cyclopropyl group, a cyclobutyl group, a cyclopentyl group, a cyclohexyl group, and a cycloheptyl group. In an embodiment, the cycloalkyl group may have 3 to 50 carbon atoms, or 3 to 18 carbon atoms, or 3 to 12 carbon atoms.

The term "heterocycloalkyl group" as used herein refers to a monovalent monocyclic group including at least one N, O, P, Si, B, Se, Ge, Te, S, or a combination thereof as a ring-forming atom in addition to the carbon atoms that are ring-forming atoms. Examples thereof include a tetrahydrofuranyl group and a tetrahydrothiophenyl group. In an embodiment, the heterocycloalkyl group may have 2 to 50 carbon atoms, or 2 to 18 carbon atoms, or 2 to 12 carbon atoms.

The term "cycloalkenyl group" as used herein refers to a monovalent monocyclic hydrocarbon group that has at least one carbon-carbon double bond in its ring, wherein the molecular structure as a whole is non-aromatic. Examples thereof include a cyclopentenyl group, a cyclohexenyl group, and a cycloheptenyl group. In an embodiment, the cycloalkenyl group may have 3 to 50 carbon atoms, or 3 to 18 carbon atoms, or 3 to 12 carbon atoms.

The term "heterocycloalkenyl group" as used herein refers to a monovalent monocyclic group including at least one N, O, P, Si, B, Se, Ge, Te, S, or a combination thereof as a ring-forming atom, and at least one double bond in its ring, wherein the molecular structure as a whole is non-aromatic. Examples of the heterocycloalkenyl group include a 2,3-dihydrofuranyl group and a 2,3-dihydrothiophenyl group. In an embodiment, the heterocycloalkenyl group may have 2 to 50 carbon atoms, or 2 to 18 carbon atoms, or 2 to 12 carbon atoms.

The term "arylalkyl group" refers to an alkyl group substituted with an aryl group. An example of an arylalkyl group is a benzyl group (i.e., -CH₂-phenyl).

The term "alkylaryl group" refers to an aryl group substituted with an alkyl group. An example of an alkylaryl group is a tolyl group.

As used herein, when a definition is not otherwise provided, "amine" is a compound represented by NR₃, wherein each R is independently hydrogen, a C1-C12 alkyl group, a C7-C20 alkylaryl group, a C7-C20 arylalkyl group, or a C6-C18 aryl group.

As used herein, the expression "not including cadmium (or other harmful heavy metal)" means that a concentration of cadmium (or another heavy metal deemed harmful) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or zero. In an embodiment, substantially no amount of cadmium (or other toxic heavy metal) may be present or, if present, an amount of cadmium (or other heavy metal) may be less than or equal to a detection limit or as an impurity level of a given analysis tool (e.g., an inductively coupled plasma atomic emission spectroscopy instrument).

Unless mentioned to the contrary, a numerical range recited herein is inclusive. Unless mentioned to the contrary, a numerical range recited herein includes any real number within the endpoints of the stated range and includes the endpoints thereof. In this specification, a numerical endpoint or an upper or lower limit value (e.g., recited either as a "greater than or equal to value" "at least value" or a "less than or equal to value" or recited with "from" or "to") may be used to form a numerical range of a given feature. In other words, the upper and lower endpoints set forth for various numerical values may be independently combined to provide a range.

"About" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ±10%, ±5%, ±3%, or ±1% of the stated value.

As used herein, a nanoparticle is a structure having at least one region or characteristic dimension with a nanoscale dimension. In an embodiment, a dimension (or an average dimension) of the nanostructure is less than or equal to about 500 nanometers (nm), less than or equal to about 300 nm, less than or equal to about 250 nm, less than or equal to about 150 nm, less than or equal to about 100 nm, less than or equal to about 50 nm, or less than or equal to about 30 nm, and may be greater than about 0.1 nm or greater than about 1 nm. In an embodiment, the nanoparticle may have any suitable shape. The nanoparticle (e.g., a semiconductor nanoparticle or a metal oxide nanoparticle) may include a nanowire, a nanorod, a nanotube, a branched nanostructure, a nanotetrapod, a nanotripod, a nanobipod, a nanodot, a multi-pod type shape such as at least two pods, or the like and is not limited thereto. The nanoparticle may be, e.g., substantially crystalline, substantially monocrystalline, polycrystalline, (for example, at least partially) amorphous, or a combination thereof.

In an embodiment, a semiconductor nanoparticle such as a quantum dot may exhibit quantum confinement or exciton confinement. As used herein, the term "quantum dot" or "semiconductor nanostructure" is not limited in a shape thereof unless otherwise defined. A semiconductor nanoparticle or a quantum dot may have a size smaller than a Bohr excitation diameter for a bulk crystal material having an identical composition and may exhibit a quantum confinement effect. The semiconductor nanoparticle or the quantum dot may emit light corresponding to a bandgap energy thereof by controlling a size of a nanocrystal acting as an emission center.

As used herein, the term "T50" is a time (hours, hr) taken until the brightness (e.g., luminance) of a given device decreases to 50% of the initial brightness (100%) as, e.g., when, the given device is started to be driven, e.g., operated, at a predetermined initial brightness (e.g., 650 nit).

As used herein, the term "T90" is a time (hr) taken until the brightness (e.g., luminance) of a given device decreases to 90% of the initial brightness (100%) as the given device is started to be driven at a predetermined initial brightness (e.g., 650 nit).

As used herein, the phrase "external quantum efficiency (EQE)" is a ratio of the number of photons emitted from a light-emitting diode (LED) to the number of electrons passing through the device and may be a measurement as to how efficiently a given device converts electrons to photons and allows the photons to escape. The EQE may be determined by the following equation: EQE = (efficiency of injection) × ((solid-state) quantum yield) × (efficiency of extraction) wherein the efficiency of injection is a proportion of electrons passing through the device that are injected into the active region, the quantum yield is a proportion of all electron-hole recombinations in the active region that are radiative and produce photons, and the efficiency of extraction is a proportion of photons generated in the active region that escape from the given device.

As used herein, a maximum EQE is a greatest value of the EQE.

As used herein, a maximum luminance is the highest value of luminance for a given device.

As used herein, the phrase "quantum efficiency" may be used interchangeably with the phrase, quantum yield. In an embodiment, the quantum efficiency may be a relative quantum yield or an absolute quantum yield, for example, which may be readily measured by any suitable, e.g., commercially available, equipment. The quantum efficiency (or quantum yield) may be measured in a solution state or a solid state (in a composite). In an embodiment, "quantum yield (or quantum efficiency)" may be a ratio of photons emitted to photons absorbed, e.g., by a nanostructure or population of nanostructures. In an embodiment, the quantum efficiency may be determined by any suitable method. For example, there may be two methods for measuring the fluorescence quantum yield or efficiency: the absolute method and the relative method.

The absolute method directly obtains the quantum yield by detecting all sample fluorescence through the use of an integrating sphere. In the relative method, the fluorescence intensity of a standard sample (e.g., a standard dye) may be compared with the fluorescence intensity of an unknown sample to calculate the quantum yield of the unknown sample. Coumarin 153, Coumarin 545, Rhodamine 101 inner salt, Anthracene, and Rhodamine 6G may be used as standard dye, depending on the photoluminescence (PL) wavelengths thereof, but are not limited thereto.

As used herein, the term "dispersion" refers to a dispersion in which a dispersed phase is a solid, and a continuous medium includes a liquid or a solid different from the dispersed phase. In an embodiment, the ink composition may be in a form of a dispersion. Herein, the "dispersion" may be a colloidal dispersion in which the dispersed phase has a dimension of greater than or equal to about 1 nm, for example, greater than or equal to about 2 nm, greater than or equal to about 3 nm, or greater than or equal to about 4 nm to several micrometers (µm) or less, (e.g., less than or equal to about 2 µm, less than or equal to about 1 µm, less than or equal to about 900 nm, less than or equal to about 800 nm, less than or equal to about 700 nm, less than or equal to about 600 nm, or less than or equal to about 500 nm).

A bandgap energy of a semiconductor nanoparticle may vary with a size and a composition of a nanocrystal. For example, as a size of the semiconductor nanoparticle increases, the bandgap energy of the semiconductor nanoparticle may become smaller, e.g., narrower, and the semiconductor nanoparticle may emit light having an increased wavelength. A semiconductor nanocrystal may be used as a light-emitting material in various fields such as in, a display device, an energy device, or a bio light-emitting device.

In the light-emitting layer, a quantum dot capable of exhibiting a practically applicable level of an electroluminescent property may include a harmful heavy metal such as cadmium (Cd), lead, mercury, or a combination thereof. Accordingly, it is desirable to provide a light-emitting device or a display device having a light-emitting layer substantially free of the harmful heavy metal. In a QD-LED, satisfactory electroluminescent properties may be based on a cadmium-based (i.e., cadmium-containing) LED, and there is room for improvement in a QD-LED device using an environmentally-friendly quantum dot and, for example, emitting blue light that does not include cadmium or other harmful heavy metals.

The semiconductor nanoparticle according to an embodiment is environmentally friendly, may emit light of a desired wavelength (e.g., a blue light) with improved luminous efficiency, and may exhibit an improved stability to the external environment. The electroluminescent device according to an embodiment includes the semiconductor nanoparticle and is a self-emissive light emitting device configured to emit a desired light by applying a voltage with or without a separate light source. The light emitting device and the display device of an embodiment are desired from an environmental point of view.

In an embodiment, the semiconductor nanoparticle may include zinc, selenium, and sulfur. The semiconductor nanoparticle may include a first semiconductor nanocrystal; and a semiconductor nanocrystal shell disposed on the first semiconductor nanocrystal and including zinc and sulfur, and the semiconductor nanoparticle may not include cadmium. The semiconductor nanoparticle may further include a plurality of organic ligands (or a ligand system including them). The plurality of organic ligands may include a first organic ligand having a carboxylate moiety; and a different second organic ligand having a carboxylate moiety. The second organic ligand may have a larger molecular weight or a greater number of carbon atoms than the first organic ligand. The semiconductor nanoparticle, in a gas chromatography (GC) analysis, may show a first peak assigned to (i.e., corresponding to) the first organic ligand and a second peak assigned to (i.e., corresponding to) the second organic ligand, and an area percentage of the first peak relative to the second peak is greater than or equal to about 0.5%, greater than or equal to about 1%, greater than or equal to about 3%, and less than or equal to about 300%, less than or equal to about 150%, less than or equal to about 130%, or less than or equal to about 99%.

An embodiment relates to an electronic device (electroluminescent device) including the semiconductor nanoparticle (e.g., in a light-emitting layer).

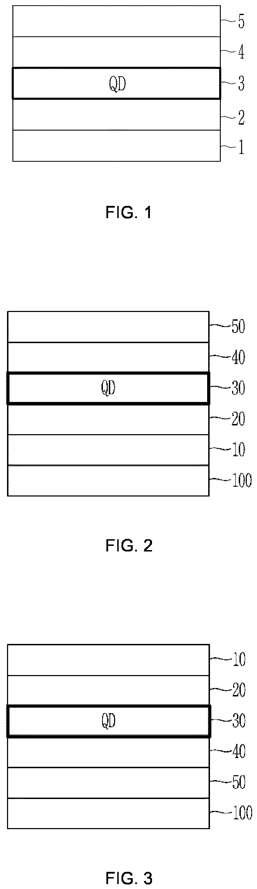

In an embodiment, an electroluminescent device may include a first electrode 1 and a second electrode 5 spaced apart from each other (e.g., each having a surface opposite the other, i.e., each with a surface facing each other); and a light emitting layer 3 disposed between the first electrode 1 and the second electrode 5. (See FIG. 1.) The light-emitting layer may include the semiconductor nanoparticle. The light-emitting layer or the semiconductor nanoparticle may not include cadmium. The first electrode may include an anode, and the second electrode may include a cathode. The first electrode may include a cathode and the second electrode may include an anode. In an embodiment, the electroluminescent device may further include a hole auxiliary layer 2 between the light emitting layer and the first electrode. In an embodiment, the electroluminescent device may further include an electron auxiliary layer 4 between the light emitting layer and the second electrode.

In the electroluminescent device of an embodiment, the first electrode 10 or the second electrode 50 may be disposed on a (transparent) substrate 100. The transparent substrate may be a light extraction surface. (See FIGS. 2 and 3).

Referring to FIG. 2 and FIG. 3, in a light emitting device of an embodiment, a light emitting layer 30 may be disposed between a first electrode (e.g., anode) 10 and a second electrode (e.g., cathode) 50. The cathode 50 may include an electron injection conductor. The anode 10 may include a hole injection conductor. The work functions of the electron/hole injection conductors included in the cathode and the anode may be appropriately adjusted and are not particularly limited. For example, the cathode may have a small work function and the anode may have a relatively large work function, or vice versa.

The electron/hole injection conductors may include a metal-based material (e.g., a metal, a metal compound, an alloy, or a combination thereof) (e.g., aluminum, magnesium, tungsten, nickel, cobalt, platinum, palladium, calcium, LiF, etc.), a metal oxide such as gallium indium oxide or indium tin oxide (ITO), or a conductive polymer (e.g., having a relatively high work function) such as polyethylene dioxythiophene, but are not limited thereto.

The first electrode, the second electrode, or a combination thereof may be a light-transmitting electrode or a transparent electrode. In an embodiment, both the first electrode and the second electrode may be a light-transmitting electrode. The electrode(s) may be patterned. The first electrode, the second electrode, or a combination thereof may be disposed on a (e.g., insulating) substrate. The substrate may be optically transparent (e.g., may have a light transmittance of greater than or equal to about 50%, greater than or equal to about 60%, greater than or equal to about 70%, greater than or equal to about 80%, greater than or equal to about 85%, or greater than or equal to about 90% and, for example, less than or equal to about 99%, or less than or equal to about 95%). The substrate may include a region for a blue pixel, a region for a red pixel, a region for a green pixel, or a combination thereof. A thin film transistor may be disposed in each region of the substrate, and one of a source electrode and a drain electrode of the thin film transistor may be electrically connected to the first electrode or the second electrode.

The light-transmitting electrode may be disposed on a (e.g., insulating) transparent substrate. The substrate may be a rigid or a flexible substrate. The substrate may include a plastic or organic material such as a polymer, an inorganic material such as a glass, or a metal.

The light-transmitting electrode may have a light transmittance of greater than or equal to about 50%, greater than or equal to about 60%, greater than or equal to about 70%, greater than or equal to about 80%, or greater than or equal to about 90%, for example, from about 80% to about 100%, from about 85% to about 95%, or a combination thereof.

The light-transmitting electrode may be made of, for example, a transparent conductor such as indium tin oxide (ITO) or indium zinc oxide ("IZO"), gallium indium tin oxide, zinc indium tin oxide, titanium nitride, polyaniline, LiF/Mg:Ag, or the like, or a metal thin film of a single layer or a plurality of layers, but is not limited thereto. If one of the first electrode and the second electrode is an opaque electrode, the opaque electrode may be made of an opaque conductor such as aluminum (Al), a lithium-aluminum (Li:AI) alloy, a magnesium-silver (Mg:Ag) alloy, or a lithium fluoride-aluminum (LiF:AI) compound. In the case of the alloy electrode, the ratio between each material may be appropriately adjusted, for example, in the range of from about 1:0.1 to about 1:10, from about 1:0.2 to about 1:5, from about 1:0.3 to about 1:3, or a combination thereof.

The multilayer electrode may include, for example, a translucent conductive material such as an indium tin oxide, an opaque conductive material such as an aluminum (or a reflective electrode material), or a combination thereof. In an embodiment, the electrode (e.g., an anode or a cathode) may have a structure in which an opaque conductive material (or a reflective electrode material layer) is disposed between translucent conductive materials (e.g., translucent conductive material layers). In an embodiment, the electrode (an anode or a cathode) may have a structure in which a translucent conductive material (e.g., a translucent conductive material layer) is disposed between opaque conductive materials (or reflective electrode materials).

As a voltage is applied between the first electrode and the second electrode, the light emitting layer may emit light upward, downward, or a combination thereof by an electric field, and the light traveling to the reflective electrode may be reflected and emitted in an opposite direction.

In an embodiment, the light may be emitted toward the cathode. In an embodiment, light may be emitted toward the anode.

A thickness of each of the electrodes (the first electrode, the second electrode, or each of the first electrode and the second electrode) is not particularly limited and may be appropriately selected taking into consideration device efficiency. For example, the thickness of the electrode may be greater than or equal to about 5 nm, greater than or equal to about 10 nm, greater than or equal to about 20 nm, greater than or equal to about 30 nm, greater than or equal to about 40 nm, or greater than or equal to about 50 nm. For example, the thickness of the electrode may be less than or equal to about 100 micrometers (µm), less than or equal to about 90 µm, less than or equal to about 80 µm, less than or equal to about 70 µm, less than or equal to about 60 µm, less than or equal to about 50 µm, less than or equal to about 40 µm, less than or equal to about 30 µm, less than or equal to about 20 µm, less than or equal to about 10 µm, less than or equal to about 1 µm, less than or equal to about 900 nm, less than or equal to about 500 nm, less than or equal to about 100 nm, less than or equal to about 90 nm, less than or equal to about 80 nm, less than or equal to about 70 nm, or less than or equal to about 60 nm.

The method of forming the electrode is not particularly limited and may be appropriately selected according to the material. In an embodiment, the electrode may be formed by a vapor deposition, a coating, or a combination thereof, but is not limited thereto.

The light emitting layer 3 or 30 disposed between the first electrode 1 and the second electrode 5 (e.g., the anode 10 and the cathode 50) may include a semiconductor nanoparticle (e.g., a blue light emitting nanoparticle, a red light emitting nanoparticle, a green light emitting nanoparticle, or a combination thereof). The light emitting layer may include one or more (e.g., 2 or more or 3 or more and 10 or less) monolayers of a plurality of nanostructures.

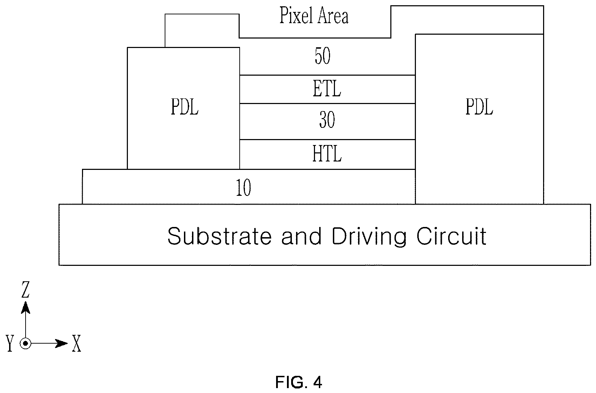

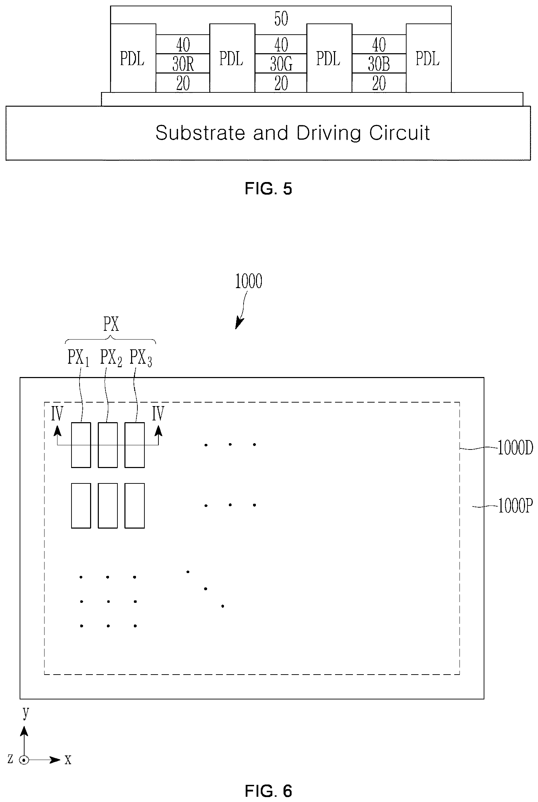

The light emitting layer may be patterned. In an embodiment, the patterned light emitting layer may include a blue light emitting layer 30B disposed in the blue pixel, a red light emitting layer 30R disposed in the red pixel, a green light emitting layer 30G disposed in the green pixel, or a combination thereof. Each of the (e.g., red, green, or blue) light emitting layers may be (e.g., optically) separated from an adjacent light emitting layer by a partition wall. In an embodiment, a partition wall such as a black matrix or a pixel defining layer (PDL) may be disposed between the red light emitting layer(s), the green light emitting layer(s), and the blue light emitting layer(s). (See FIG. 4 and FIG. 5) The red light emitting layer, the green light emitting layer, and the blue light emitting layer may be optically isolated from each other.

The light emitting layer or the semiconductor nanoparticles may not include cadmium. The light emitting layer or the semiconductor nanoparticles may not include lead, mercury, or a combination thereof. The semiconductor nanoparticle may further include or may not include copper, manganese, or a combination thereof

The semiconductor nanoparticle included in the light emitting layer 3 or 30 may include zinc, selenium, and sulfur. An embodiment provides the semiconductor nanoparticle or a population thereof.

In an embodiment, the semiconductor nanoparticle includes zinc, selenium, and sulfur. The semiconductor nanoparticle may have a core-shell structure. The semiconductor nanoparticle or the core-shell structure includes a first semiconductor nanocrystal; and a semiconductor nanocrystal shell disposed on the first semiconductor nanocrystal and including zinc and sulfur (e.g., including a third semiconductor nanocrystal).

The semiconductor nanoparticle or the first semiconductor nanocrystal may include an indium phosphide, an indium zinc phosphide, a zinc selenide, a zinc telluride, a zinc tellurium selenide (e.g., a zinc selenide telluride, a tellurium- (or selenium-) doped zinc selenide (or telluride)), a silver indium gallium sulfide, a silver indium sulfide, or a combination thereof.

The semiconductor nanoparticle or the semiconductor nanocrystal shell may include a zinc selenide, a zinc selenide telluride, a zinc selenide sulfide, a zinc sulfide, or a combination thereof. The semiconductor nanocrystal shell may include a first shell layer (including a second semiconductor nanocrystal); and a second shell layer disposed on the first shell layer and including, for example, a third semiconductor nanocrystal. The first shell layer or the second semiconductor nanocrystal may include a zinc selenide, a zinc selenide telluride, a zinc selenide sulfide, or a combination thereof. The second shell layer or the third semiconductor nanocrystal may include a zinc selenide sulfide, a zinc sulfide, or a combination thereof. In an embodiment, the core-shell type semiconductor nanoparticle may include a semiconductor nanocrystal shell on the first semiconductor nanocrystal (or a core including the same). Depending on the composition of the first semiconductor nanocrystal and the semiconductor nanocrystal shell, the semiconductor nanoparticle may have an energy band alignment of type I, type II, or quasi-type II, and may be configured to emit light of a desired wavelength upon application of a voltage.

In an embodiment, the semiconductor nanoparticle, the first semiconductor nanocrystal, or the semiconductor nanocrystal shell (e.g., the second semiconductor nanocrystal or the third semiconductor nanocrystal) may each independently include a group II-VI compound, a group III-V compound, a group IV-VI compound, a group IV element or compound, a group II-III-VI compound, a group I-III-VI compound, a group I-II-IV-VI compound, or a combination thereof.

The Group II-VI compound may include a binary element compound such as ZnS, ZnSe, ZnTe, ZnO, HgS, HgSe, HgTe, MgSe, MgS, or a combination thereof; a ternary element compound such as ZnSeS, ZnSeTe, ZnSTe, HgSeS, HgSeTe, HgSTe, HgZnS, HgZnSe, HgZnTe, MgZnSe, MgZnS, or a combination thereof; a quaternary element compound such as HgZnTeS, HgZnSeS, HgZnSeTe, HgZnSTe, or a combination thereof; or a combination thereof. The Group II-VI compound may further include a Group III metal.

The Group III-V compound may include a binary element compound such as GaN, GaP, GaAs, GaSb, AIN, AIP, AlAs, AlSb, InN, InP, InAs, InSb, or a combination thereof; a ternary element compound such as GaNP, GaNAs, GaNSb, GaPAs, GaPSb, AINP, AINAs, AINSb, AIPAs, AlPSb, InNP, InNAs, InNSb, InPAs, InPSb, or a combination thereof; a quaternary element compound such as GaAINP, GaAINAs, GaAINSb, GaAIPAs, GaAIPSb, GalnNP, GalnNAs, GaInNSb, GalnPAs, GalnPSb, InAINP, InAINAs, InAINSb, InAIPAs, InAIPSb, or a combination thereof; or a combination thereof. The Group III-V compound may further include a Group II metal (e.g., InZnP).

The Group IV-VI compound may include a binary element compound such as SnS, SnSe, SnTe, PbS, PbSe, PbTe, or a combination thereof; a ternary element compound such as SnSeS, SnSeTe, SnSTe, PbSeS, PbSeTe, PbSTe, SnPbS, SnPbSe, SnPbTe, or a combination thereof; a quaternary element compound such as SnPbSSe, SnPbSeTe, SnPbSTe, or a combination thereof; or a combination thereof.

Examples of the Group I-III-VI compound may include CuInSe₂, CuInS₂, CuInGaSe, and CulnGaS, but are not limited thereto. Examples of the Group I-III-VI compound may include a ternary element compound such as AgInS, AgInS₂, AgInSe₂, AgGaS, AgGaS₂, AgGaSe₂, CulnS, CuInS₂, CuInSe₂, CuGaS₂, CuGaSe₂, CuGaO₂, AgGaO₂, AgAlO₂ or a combination thereof; a quaternary element compound such as AgInGaS₂, AgInGaSe₂; or a combination thereof.

Examples of the Group I-II-IV-VI compound may be CuZnSnSe, and CuZnSnS, but are not limited thereto.

The Group IV element or compound may include a single element such as Si, Ge, or a combination thereof; a binary element compound such as SiC, SiGe, or a combination thereof; or a combination thereof.

Each element included in a multi-element compound such as a binary element compound, a ternary element compound, or a quaternary element compound may be present in the particle at a uniform concentration or at a non-uniform concentration. For example, the chemical formula described above means the types of elements included in the compound, and the ratio among the elements in the compound may be different. For example, the chemical formula "AgInGaS₂"may include AgInₓGa₁₋ₓS₂ (x is a real number of greater than 0 to less than 1), but is not limited thereto.

In an embodiment, the first semiconductor nanocrystal may include a metal including indium, zinc, or a combination thereof, and a non-metal element including phosphorus, selenium, tellurium, sulfur, or a combination thereof. In an embodiment, the second semiconductor nanocrystal may include a metal including indium, zinc, or a combination thereof, and a non-metal element including phosphorus, selenium, tellurium, sulfur, or a combination thereof.

In an embodiment, the first semiconductor nanocrystal may include InP, InZnP, ZnSe, ZnSeS, ZnSeTe, or a combination thereof; the second semiconductor nanocrystal may include ZnSe, ZnSeS, ZnS, ZnTeSe, or a combination thereof. In an embodiment, the shell may include zinc, sulfur, and optionally selenium for example in the outermost layer.

In an embodiment, the semiconductor nanoparticle may emit blue or green light and may include a core including ZnSeTe, ZnSe, or a combination thereof, and a shell including a zinc chalcogenide (e.g., ZnS, ZnSe, ZnSeS, or a combination thereof). An amount of sulfur in the shell may increase or decrease in a radial direction (from the core toward the surface), e.g., the amount of sulfur may have a concentration gradient wherein the concentration of sulfur varies radially (e.g., decreases or increases in a direction toward the core).

In an embodiment, the semiconductor nanoparticle may emit red or green light, the core may include InP, InZnP, or a combination thereof, and the shell may include a Group II metal including zinc and a non-metal including sulfur, selenium, or a combination thereof.

In an embodiment, the semiconductor nanoparticle may have a core-shell structure, and on the interface between the core and the shell, an alloyed interlayer may be present or may not be present. The alloyed interlayer layer may include a homogeneous alloy or may have a concentration gradient. The gradient alloy may have a concentration gradient wherein the concentration of an element of the shell varies radially (e.g., decreases or increases in a direction toward the core).

In an embodiment, the shell may have a composition that varies in a radial direction. In an embodiment, the shell may be a multilayered shell including two or more layers. In a multilayered shell, adjacent two layers may have different compositions from each other. In a multilayered shell, a, e.g., at least one, layer may independently include a semiconductor nanocrystal having a single composition. In a multilayered shell, a, e.g., at least one, layer may independently have an alloyed semiconductor nanocrystal. In a multilayered shell, a, e.g., at least one, layer may have a concentration gradient that varies radially in terms of a composition of a semiconductor nanocrystal.

In an embodiment, in the semiconductor nanoparticle having a core-shell structure, a shell material may have a bandgap energy that is greater than that of the core. The materials of the shell may have a bandgap energy that is less than that of the core. In the case of a multilayered shell, the bandgap energy of the outermost layer material of the shell may be greater than the bandgap energies of the core and the inner layer material of the shell (layers that are closer to the core). In the case of a multilayered shell, a semiconductor nanocrystal of each layer is selected to have an appropriate bandgap, thereby effectively exhibiting a quantum confinement effect.

An absorption or emission wavelength of the semiconductor nanoparticle may be controlled by adjusting the compositions, the particle size, or a combination thereof, of the semiconductor nanoparticle. The semiconductor nanoparticle included in the light-emitting layer 3, or 30, may emit light of a desired color. The semiconductor nanoparticle may include a blue light-emitting semiconductor nanoparticle, a green light-emitting semiconductor nanoparticle, or a red light-emitting semiconductor nanoparticle. In an embodiment, the light emitting layer may be configured to emit blue light, green light, or red light, and wavelengths of blue light, green light, and red light are as described herein.

In an embodiment, a peak emission wavelength of the semiconductor nanoparticle or a light emission layer (or the light emitted from the electroluminescent device) may be in a wavelength range from ultraviolet to infrared. In an embodiment, the peak emission wavelength of the semiconductor nanoparticle or the light-emitting layer (or the light emitted from the electroluminescent device) may be greater than or equal to about 300 nm, greater than or equal to about 500 nm, greater than or equal to about 510 nm, greater than or equal to about 520 nm, greater than or equal to about 530 nm, greater than or equal to about 540 nm, greater than or equal to about 550 nm, greater than or equal to about 560 nm, greater than or equal to about 570 nm, greater than or equal to about 580 nm, greater than or equal to about 590 nm, greater than or equal to about 600 nm, or greater than or equal to about 610 nm. The peak emission wavelength may be less than or equal to about 800 nm, less than or equal to about 650 nm, less than or equal to about 640 nm, less than or equal to about 630 nm, less than or equal to about 620 nm, less than or equal to about 610 nm, less than or equal to about 600 nm, less than or equal to about 590 nm, less than or equal to about 580 nm, less than or equal to about 570 nm, less than or equal to about 560 nm, less than or equal to about 550 nm, or less than or equal to about 540 nm. The peak emission wavelength may be from about 500 nm to about 650 nm.

The semiconductor nanoparticle, the light-emitting layer, or the electroluminescent device may emit a green light (for example, on an application of a voltage or irradiation with light) and a peak emission wavelength thereof may be in the range of greater than or equal to about 500 nm (for example, greater than or equal to about 510 nm, or greater than or equal to about 515 nm) and less than or equal to about 560 nm, for example, less than or equal to about 540 nm, or less than or equal to about 530 nm. The semiconductor nanoparticle, the light-emitting layer, or the electroluminescent device may emit a red light (for example, on an application of voltage or irradiation with light), and a peak emission wavelength thereof may be in the range of greater than or equal to about 600 nm, for example, greater than or equal to about 610 nm and less than or equal to about 650 nm, or less than or equal to about 640 nm. The semiconductor nanoparticle, the light-emitting layer, or the electroluminescent device may emit a blue light (for example, on an application of voltage or irradiation with light), and a peak emission wavelength thereof may be greater than or equal to about 430 nm (for example, greater than or equal to about 450 nm, greater than or equal to about 455 nm, greater than or equal to about 460 nm, or greater than or equal to about 465 nm) and less than or equal to about 480 nm (for example, less than or equal to about 475 nm, less than or equal to about 470 nm, or less than or equal to about 465 nm).

In an embodiment, the semiconductor nanoparticle, the light-emitting layer, or the electroluminescent device may exhibit a luminescent spectrum (e.g., photoluminescent or electroluminescent spectrum) with a relatively narrow full width at half maximum. In an embodiment, in the photoluminescent or electroluminescent spectrum, the semiconductor nanoparticle, the light-emitting layer, or the electroluminescent device may exhibit a full width at half maximum of less than or equal to about 45 nm, less than or equal to about 44 nm, less than or equal to about 43 nm, less than or equal to about 42 nm, less than or equal to about 41 nm, less than or equal to about 40 nm, less than or equal to about 39 nm, less than or equal to about 38 nm, less than or equal to about 37 nm, less than or equal to about 36 nm, or less than or equal to about 35 nm. The full width at half maximum may be greater than or equal to about 10 nm, greater than or equal to about 15 nm, greater than or equal to about 20 nm, or greater than or equal to about 25 nm.

The semiconductor nanoparticle may have a quantum yield of greater than or equal to about 10%, for example, greater than or equal to about 20%, greater than or equal to about 30%, greater than or equal to about 40%, greater than or equal to about 50%, greater than or equal to about 60%, greater than or equal to about 70%, greater than or equal to about 80%, greater than or equal to about 90%, or even about 100% (e.g., configured to achieve this). In an embodiment, the semiconductor nanoparticle may have a quantum yield (or absolute quantum yield) of greater than or equal to about 91%, greater than or equal to about 92%, greater than or equal to about 93%, greater than or equal to about 94%, greater than or equal to about 95%, greater than or equal to about 96%, or greater than or equal to about 97%.

The semiconductor nanoparticle may have a size or an average size, (hereinafter, may be simply referred to as "size") of greater than or equal to about 1 nm and less than or equal to about 100 nm. The size may be a diameter or equivalent diameter converted by assuming a spherical shape from an electron microscope image when not spherical. The size may be calculated from a result of an inductively coupled plasma atomic emission spectroscopy (ICP-AES) analysis. In an embodiment, the semiconductor nanoparticle may have a size of from about 1 nm to about 50 nm, for example, from about 2 nm (or about 3 nm) to about 35 nm. In an embodiment, a size (or an average size) of the semiconductor nanoparticle may be greater than or equal to about 3 nm, greater than or equal to about 4 nm, greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm. In an embodiment, the size of the semiconductor nanoparticle may be less than or equal to about 50 nm, less than or equal to about 40 nm, less than or equal to about 30 nm, less than or equal to about 25 nm, less than or equal to about 20 nm, less than or equal to about 19 nm, less than or equal to about 18 nm, less than or equal to about 17 nm, less than or equal to about 16 nm, less than or equal to about 15 nm, less than or equal to about 14 nm, less than or equal to about 13 nm, or less than or equal to about 12 nm.

A shape of the semiconductor nanoparticle or the semiconductor nanostructure is not particularly limited. For example, the shape of the semiconductor nanoparticle may include, but is not limited to, a sphere, a polyhedron, a pyramid, a multi-pod shape, a hexahedron, a cube, a cuboid, a nanotube, a nanorod, a nanowire, or a nanosheet.

As a light-emitting material, there is a growing interest in electroluminescent devices that include an inorganic-based semiconductor nanoparticle. A semiconductor nanoparticle-based electroluminescent device (e.g., QD light emitting diode, QD-LED) utilizes the electroluminescence of a semiconductor nanoparticle through the injection and recombination of electrons and holes in the semiconductor nanoparticle such as a quantum dot, and have high potential for use in various electronic devices (e.g., display devices). A semiconductor nanoparticle-based electroluminescent device may not require a separate backlight and may be provided in a thin structure. Therefore, there is active research in various fields to modify semiconductor nanoparticles to improve the performance of electroluminescent devices. For example, research is being conducted regarding an electroluminescent device including a cadmium-free quantum dot that does not contain harmful heavy metal such as cadmium. One area of focus is on core-shell type semiconductor nanoparticles having a core including a first semiconductor nanocrystal and a semiconductor nanocrystal shell disposed on the core. Additionally, research is being conducted to provide such a QD LED device through a cost-effective solution process such as an inkjet printing method.

The present inventors have found that, in the prior art, the Zn precursor used during the growth of the shell (e.g., the outermost shell including zinc sulfide) can affect not only the shell coating quality of the resulting semiconductor nanoparticle but also the composition of the organic ligand of the semiconductor nanoparticle. Without wishing to be bound by any theory, it is believed that in the Zn precursor according to the prior art, it is difficult to provide the desired level of coating speed, and relatively high lattice strain may exist at the growth interface. Additionally, the Zn precursor used in the formation of the outermost layer in the prior art may include relatively long organic chains, which can affect an electroluminescent property of a QD-LED device and hinder the improvement of the lifespan of the device.

Regarding the organic ligand composition, it is possible to replace an organic ligand having a relatively long organic chain with a short-chain organic ligand or an inorganic ligand (e.g., a halide). However, the method of the prior art inevitably involves an additional process (e.g., a separate ligand exchange process) to control a ligand composition of the semiconductor nanoparticle, which not only increases manufacturing cost but also has a technical drawback, i.e., adversely affecting a luminescent property of the resulting semiconductor nanoparticle. In addition, the present inventors have also found that the organic ligand having relatively long organic chains disposed on a surface of semiconductor nanoparticles may be advantageous for improving a dispersion property of a particle (e.g., when halides coexist), but when included in device, they are likely to adversely affect a property such as a lifespan of the device.

In an embodiment, in the forming of a semiconductor nanocrystal shell (or outermost shell layer) including a zinc sulfide, a zinc precursor (e.g., a first zinc precursor) having a carboxylate moiety derived from a carboxylic acid with a relatively low acid dissociation constant (pKa) (e.g., less than or equal to about 8, or less than or equal to about 7.5) is used in combination with a zinc precursor (a second zinc precursor) having a carboxylate moiety derived from a carboxylic acid with a relatively high acid dissociation constant (e.g., greater than or equal to about 8.8, or greater than or equal to about 9 and less than or equal to about 12) in the manner described herein, and also employs the use of a metal halide. The inventors have surprisingly found that, based on the method described herein, combining the zinc precursors during the synthesis of the semiconductor nanoparticle can provide a high-quality shell coating at a desired coating speed and also provide a semiconductor nanoparticle with an optimized ligand composition. Without wishing to be bound by any theory, it is believed that, in an embodiment, the combination of the first zinc precursor and the second zinc precursor allows the reaction rate of shell formation to be controlled within a desired range, and reduces lattice strain at a growth interface of the semiconductor nanocrystal shell. The combination of the first zinc precursor and the second zinc precursor can contribute to suppressing particle agglomeration due to the addition of the metal halide, and the semiconductor nanoparticle thus prepared includes the ligand system described herein, which makes it possible to obtain an improved dispersion property desired for a solution process such as an inkjet process and to minimize an adverse impact on electroluminescent properties and device lifespan that can otherwise occur without the ligand system.

Therefore, the semiconductor nanoparticle of an embodiment further includes a plurality of organic ligands or a ligand system including them. The plurality of organic ligands or ligand system may be bound or disposed on a surface of the semiconductor nanoparticle (or a semiconductor nanocrystal shell). The semiconductor nanoparticle or the ligand system can further include a halogen (e.g., a halide).

The ligand system or the plurality of organic ligands may include a hydrocarbon group. A total number of the carbon atoms in the ligand system or the plurality of organic ligand molecules (or molecular formulas) may be greater than or equal to about 20, greater than or equal to about 21, greater than or equal to about 22, greater than or equal to about 23, greater than or equal to about 24, greater than or equal to about 25, greater than or equal to about 26, greater than or equal to about 27, greater than or equal to about 28, or greater than or equal to about 29. The total number of the carbon atoms may be less than or equal to about 40, less than or equal to about 38, less than or equal to about 36, less than or equal to about 35, less than or equal to about 34, less than or equal to about 33, less than or equal to about 32, less than or equal to about 31, less than or equal to about 30, less than or equal to about 29, less than or equal to about 28, or less than or equal to about 27.

The ligand system or the plurality of organic ligands may include a first organic ligand having a carboxylate moiety; and a second organic ligand different from the first organic ligand and also having a carboxylate moiety. The first organic ligand may be derived from the first zinc precursor (as described herein). The second organic ligand may be derived from the second zinc precursor (as described herein). The molecular weight (or number of carbon atoms) of the second organic ligand may be greater than that of the first organic ligand.

The first organic ligand may have a molecular weight of greater than or equal to about 90 g/mol, greater than or equal to about 100 g/mol, greater than or equal to about 105 g/mol, greater than or equal to about 110 g/mol, greater than or equal to about 115 g/mol, greater than or equal to about 120 g/mol, greater than or equal to about 125 g/mol, greater than or equal to about 130 g/mol, greater than or equal to about 140 g/mol, greater than or equal to about 150 g/mol, greater than or equal to about 160 g/mol, greater than or equal to about 170 g/mol, greater than or equal to about 180 g/mol, greater than or equal to about 190 g/mol, or greater than or equal to about 200 g/mol. The first organic ligand may have a molecular weight of less than or equal to about 257 g/mol, less than or equal to about 230 g/mol, less than or equal to about 225 g/mol, less than or equal to about 220 g/mol, less than or equal to about 215 g/mol, less than or equal to about 210 g/mol, less than or equal to about 200 g/mol, less than or equal to about 190 g/mol, less than or equal to about 180 g/mol, less than or equal to about 170 g/mol, less than or equal to about 160 g/mol, less than or equal to about 155 g/mol, less than or equal to about 150 g/mol, less than or equal to about 145 g/mol, less than or equal to about 140 g/mol, or less than or equal to about 130 g/mol.

The first organic ligand may include a hydrocarbon group, e.g., an aliphatic, aromatic, or alicyclic hydrocarbon group. The hydrocarbon group of the first organic ligand may include a substituted or unsubstituted C6-C18 aromatic hydrocarbon group, or a substituted or unsubstituted, C2-C16, C2-C14, C3-C12, C4-C10, C5-C9, C4-C8, or C6-C7, linear or branched aliphatic hydrocarbon group (e.g., an alkyl group, an alkenyl group, or an alkynyl group). The first organic ligand may include a branched alkyl group. The first organic ligand may include a propanoate moiety, an isopropanoate moiety, a butyrate moiety, a butyrate moiety having one or more C1-C3 alkyl groups (e.g., a methylbutyrate moiety or an ethylbutyrate moiety), a valerate (or pentanoic acid ester) moiety, a valerate moiety substituted with one or more C1-C4 alkyl group (e.g., a methylvalerate moiety or an ester of propylpentanoic acid), a hexanoate moiety, a hexanoate moiety substituted with one or more C1-C5 alkyl groups (e.g., a ethylhexanoate moiety), an octanoate moiety, an octanoate moiety substituted with a C1-C6 alkyl group (e.g., a butyloctanoate moiety), or a combination thereof.

The first organic ligand may include a carboxylate moiety (e.g., a carboxylate anion) represented by Chemical Formula 1, and the total number of carbon atoms in the first organic ligand is 3 to 15, or 4 to 13, or 5 to 11, or 6 to 10:

Chemical Formula 1 **R-(CR₂)ₙ-COO**

wherein R is the same or different and is each independently hydrogen or a C1-C6, or C2-C4, or C3-C5 alkyl group (e.g., methyl group, ethyl group, propyl group, butyl group, pentyl group, or hexyl group), and n is an integer of 1 to 14, or 2 to 12, or 3 to 10, or 4 to 8.

The second organic ligand may have a larger molecular weight or a greater number of carbon atoms than the first organic ligand. A difference in the molecular weight between the second organic ligand and the first organic ligand may be greater than or equal to about 50 g/mol, greater than or equal to about 75 g/mol, greater than or equal to about 80 g/mol, greater than or equal to about 90 g/mol, greater than or equal to about 100 g/mol, greater than or equal to about 120 g/mol, greater than or equal to about 130 g/mol, or greater than or equal to about 150 g/mol. The difference in the molecular weight between the second organic ligand and the first organic ligand may be less than or equal to about 240 g/mol, less than or equal to about 220 g/mol, less than or equal to about 200 g/mol, less than or equal to about 180 g/mol, less than or equal to about 160 g/mol, less than or equal to about 150 g/mol, less than or equal to about 140 g/mol, less than or equal to about 130 g/mol, less than or equal to about 120 g/mol, less than or equal to about 100 g/mol, or less than or equal to about 90 g/mol.

The second organic ligand may have a molecular weight of greater than about 200 g/mol, greater than or equal to about 210 g/mol, greater than or equal to about 215 g/mol, greater than or equal to about 220 g/mol, greater than or equal to about 225 g/mol, greater than or equal to about 230 g/mol, greater than or equal to about 235 g/mol, greater than or equal to about 240 g/mol, greater than or equal to about 245 g/mol, greater than or equal to about 250 g/mol, greater than or equal to about 255 g/mol, greater than or equal to about 260 g/mol, greater than or equal to about 265 g/mol, greater than or equal to about 270 g/mol, or greater than or equal to about 280 g/mol. The second organic ligand may have a molecular weight of less than or equal to about 500 g/mol, less than or equal to about 450 g/mol, less than or equal to about 440 g/mol, less than or equal to about 430 g/mol, less than or equal to about 420 g/mol, less than or equal to about 410 g/mol, less than or equal to about 400 g/mol, less than or equal to about 390 g/mol, less than or equal to about 380 g/mol, less than or equal to about 370 g/mol, less than or equal to about 360 g/mol, less than or equal to about 350 g/mol, less than or equal to about 340 g/mol, or less than or equal to about 250 g/mol.

The second organic ligand may include a C12-C25, C13-C23, C14-C22, C16-C21, C17-C20, or C18-C19 linear or branched aliphatic hydrocarbon group (e.g., an alkyl group, an alkenyl group, or an alkynyl group). The second organic ligand may include a tetradecyl group, a tetradecenyl group, a pentadecyl group, a pentadecenyl group, a hexadecyl group, a hexadecenyl group, a heptadecyl group, a heptadecenyl group, an octadecyl group, an octadecenyl group, an octadecadienyl group, an octadecatrienyl group, or a combination thereof.

The second organic ligand can include, for example, a carbon-carbon double bond within the aliphatic hydrocarbon group chain. The second organic ligand may include a linolenate moiety, a linoleate moiety, an oleate moiety, an elaidate moiety, a stearate moiety, a palmitate moiety, a myristate moiety, or a combination thereof.

In an embodiment, the first organic ligand may include a branched alkyl group, and the second organic ligand may include a linear alkenyl group.

In an embodiment, the semiconductor nanoparticle may include both the first organic ligand and the second organic ligand, and in a gas chromatography (GC) analysis (e.g., in the chromatogram obtained by gas chromatography analysis), may show a first peak assigned to the first organic ligand and a second peak assigned to the second organic ligand. In the semiconductor nanoparticle of an embodiment, the area percentage of the first peak relative to the second peak may be greater than or equal to about 1%, or greater than or equal to about 3%, and less than or equal to about 200%, or less than or equal to about 99%. In an embodiment, the area percentage of the first peak relative to the second peak may be greater than or equal to about 5%, greater than or equal to about 7%, greater than or equal to about 10%, greater than or equal to about 15%, greater than or equal to about 17%, greater than or equal to about 19%, greater than or equal to about 20%, greater than or equal to about 21%, greater than or equal to about 23%, greater than or equal to about 25%, greater than or equal to about 27%, greater than or equal to about 29%, greater than or equal to about 30%, greater than or equal to about 31%, greater than or equal to about 33%, greater than or equal to about 35%, greater than or equal to about 37%, greater than or equal to about 39%, greater than or equal to about 40%, greater than or equal to about 41%, greater than or equal to about 43%, greater than or equal to about 45%, greater than or equal to about 47%, greater than or equal to about 49%, greater than or equal to about 50%, greater than or equal to about 51%, greater than or equal to about 53%, greater than or equal to about 55%, greater than or equal to about 57%, greater than or equal to about 59%, greater than or equal to about 60%, greater than or equal to about 61%, greater than or equal to about 63%, greater than or equal to about 65%, greater than or equal to about 67%, greater than or equal to about 69%, greater than or equal to about 70%, greater than or equal to about 71%, greater than or equal to about 73%, greater than or equal to about 75%, greater than or equal to about 77%, greater than or equal to about 79%, greater than or equal to about 81%, greater than or equal to about 83%, greater than or equal to about 85%, greater than or equal to about 87%, greater than or equal to about 89%, greater than or equal to about 90%, greater than or equal to about 91%, greater than or equal to about 93%, greater than or equal to about 95%, greater than or equal to about 97%, greater than or equal to about 99%, greater than or equal to about 100%, greater than or equal to about 101%, greater than or equal to about 103%, greater than or equal to about 105%, greater than or equal to about 107%, greater than or equal to about 109%, or greater than or equal to about 110%. The area percentage of the first peak relative to the second peak may be less than or equal to about 400%, less than or equal to about 350%, less than or equal to about 300%, less than or equal to about 250%, less than or equal to about 200%, less than or equal to about 190%, less than or equal to about 180%, less than or equal to about 170%, less than or equal to about 160%, less than or equal to about 150%, less than or equal to about 140%, less than or equal to about 130%, less than or equal to about 120%, less than or equal to about 110%, less than or equal to about 98%, or less than or equal to about 97%.

The retention time (i.e., acquisition time) of the second peak may be longer than the retention time of the first peak. A ratio of the retention time of the first peak (elution time of the first organic ligand peak) to the retention time of the second peak (elution time of the second organic ligand peak) may be greater than or equal to about 0.1:1, greater than or equal to about 0.2:1, greater than or equal to about 0.3:1, greater than or equal to about 0.4:1, greater than or equal to about 0.5:1, greater than or equal to about 0.6:1, or greater than or equal to about 0.7:1. The ratio of the retention times may be less than or equal to about 1:1, less than or equal to about 0.9:1, less than or equal to about 0.8:1, or less than or equal to about 0.7:1. A difference in retention time between the second peak and the first peak may be greater than or equal to about 1 minute, greater than or equal to about 2 minutes, greater than or equal to about 3 minutes, greater than or equal to about 4 minutes, or greater than or equal to about 5 minutes, greater than or equal to about 6 minutes, greater than or equal to about 7 minutes, greater than or equal to about 8 minutes, greater than or equal to about 9 minutes, greater than or equal to about 10 minutes. The difference in retention time between the second peak and the first peak may be less than or equal to about 15 minutes, less than or equal to about 13 minutes, less than or equal to about 12 minutes, less than or equal to about 11 minutes, less than or equal to about 10 minutes, less than or equal to about 9 minutes, less than or equal to about 7 minutes, less than or equal to about 5 minutes, or less than or equal to about 2 minutes.

A gas chromatography (GC) is an analytical technique that may be used to separate, identify, and quantify individual chemical components in complex mixtures. In the GC, a gas carries a sample through the GC instrument. In an embodiment, a carrier gas or a mobile phase is not particularly limited and may be a high-purity helium, hydrogen, or nitrogen. In an embodiment, the gas chromatography analysis apparatus may include an injector (e.g., split/splitless (SSL) injector), a column (e.g., a wall-coated open tubular (WCOT) capillary column including a thin layer of dimethylpolysiloxane stationary phase), and a detector (e.g., flame ionization detector, FID, or mass spectrometry, MS), but is not limited thereto. In an embodiment, the GC column may be a capillary column and may be a fused silica capillary tube including a polymer outer coating. In the chromatogram obtained by GC, the x-axis represents retention time (typically in minutes) and the y-axis represents detector response. In an embodiment, the GC apparatus may be py-GC/MS. In the GC, the temperature of the pyrolyzer may be 400°C to 600°C or 450°C to 550°C. The GC apparatus may include a capillary column. The capillary column may include a stationary phase of polysiloxane (e.g., dimethylpolysiloxane, 5% to 65% diphenyldimethylpolysiloxane, polyethylene glycol, etc.), and the polarity may be appropriately selected.

The flow rate of the mobile phase (gas) may be appropriately selected and may be in the range of 0.5 milliliter per minute (mL/min) to 10 mL/min, or 1 mL/min to 5 mL/min, or 1.5 mL/min to 3 mL/min. The inlet temperature of the GC apparatus may be appropriately selected and may be in the range of 100°C to 400°C, 150°C to 300°C, or 200°C to 250°C. The GC oven temperature may be appropriately controlled. The analyzer may be a quadrupole (range: 10 ~ 550 mass-to-charge ratio (m/z)).

The semiconductor nanoparticle of an embodiment, as confirmed by thermogravimetric analysis, can exhibit a relatively reduced organic content but can still show a desired level of dispersibility in an organic solvent (e.g., aliphatic hydrocarbon solvent such as octane). In the thermogravimetric analysis, the semiconductor nanoparticle of an embodiment can exhibit a weight loss in the range of 200°C to 550°C that is less than or equal to about 13 weight percent (wt%), less than or equal to about 12 wt%, less than or equal to about 11.5 wt%, less than or equal to about 11 wt%, less than or equal to about 10.5 wt%, less than or equal to about 10 wt%, less than or equal to about 9.5 wt%, or less than or equal to about 8 wt%, based on a total weight of the semiconductor nanoparticle. In thermogravimetric analysis, the semiconductor nanoparticle may exhibit a weight loss in the range of 200°C to 550°C of greater than or equal to about 1 wt%, greater than or equal to about 3 wt%, greater than or equal to about 5 wt%, or greater than or equal to about 7 wt%, based on a total weight of the semiconductor nanoparticle.

The semiconductor nanoparticle, in thermogravimetric analysis, may have a residual content at a temperature of about 550°C or greater, that is greater than or equal to about 80 wt%, greater than or equal to about 83 wt%, greater than or equal to about 87 wt%, or greater than or equal to about 88 wt%, or greater than or equal to about 90 wt%, or greater than or equal to about 91 wt%, and less than or equal to about 99 wt%, less than or equal to about 97 wt%, less than or equal to about 92 wt%, or less than or equal to about 90 wt%, based on a total weight of the semiconductor nanoparticle.

The semiconductor nanoparticle can exhibit improved dispersibility in an organic solvent (e.g., aliphatic hydrocarbon solvent such as octane). In an embodiment, the semiconductor nanoparticle, when dispersed in octane and measured by dynamic light scattering analysis, can exhibit a DLS particle diameter of less than about 300 nm. The DLS particle diameter may be less than or equal to about 200 nm, less than or equal to about 100 nm, less than or equal to about 80 nm, less than or equal to about 60 nm, less than or equal to about 50 nm, less than or equal to about 40 nm, less than or equal to about 30 nm, or less than or equal to about 20 nm. The DLS particle diameter may be greater than or equal to about 5 nm, greater than or equal to about 7 nm, greater than or equal to about 10 nm, greater than or equal to about 15 nm, or greater than or equal to about 20 nm.

The semiconductor nanoparticle may further include a halogen, e.g., in the form of a halide. The halogen may be fluorine, chlorine, bromine, iodine, or a combination thereof. In one embodiment, the halogen may be chlorine, e.g., chloride.

In the semiconductor nanoparticle, a mole ratio of halogen to zinc may be greater than or equal to about 0.005:1, greater than or equal to about 0.01:1, greater than or equal to about 0.02:1, greater than or equal to about 0.03:1, greater than or equal to about 0.04:1, greater than or equal to about 0.05:1, greater than or equal to about 0.08:1, greater than or equal to about 0.1:1, greater than or equal to about 0.15:1, or greater than or equal to about 0.2:1. In the semiconductor nanoparticle, the mole ratio of halogen to zinc may be less than or equal to about 1:1, less than or equal to about 0.9:1, less than or equal to about 0.7:1, less than or equal to about 0.6:1, less than or equal to about 0.4:1, less than or equal to about 0.2:1, less than or equal to about 0.12:1, less than or equal to about 0.09:1, less than or equal to about 0.07:1, less than or equal to about 0.06:1, or less than or equal to about 0.05:1.

In the semiconductor nanoparticle, a mole ratio of halogen to selenium may be greater than or equal to about 0.005:1, greater than or equal to about 0.01:1, greater than or equal to about 0.02:1, greater than or equal to about 0.03:1, greater than or equal to about 0.04:1, greater than or equal to about 0.05:1, greater than or equal to about 0.08:1, greater than or equal to about 0.1:1, greater than or equal to about 0.15:1, or greater than or equal to about 0.2:1. In the semiconductor nanoparticle, the mole ratio of halogen to selenium may be less than or equal to about 1:1, less than or equal to about 0.9:1, less than or equal to about 0.7:1, less than or equal to about 0.6:1, less than or equal to about 0.4:1, less than or equal to about 0.2:1, less than or equal to about 0.12:1, less than or equal to about 0.09:1, less than or equal to about 0.07:1, less than or equal to about 0.06:1, or less than or equal to about 0.05:1.

In the semiconductor nanoparticle, a mole ratio of carbon to zinc may be greater than or equal to about 0.005:1, greater than or equal to about 0.01:1, greater than or equal to about 0.05:1, greater than or equal to about 0.1:1, greater than or equal to about 0.15:1, greater than or equal to about 0.2:1, greater than or equal to about 0.25:1, greater than or equal to about 0.3:1, greater than or equal to about 0.35:1, greater than or equal to about 0.4:1, or greater than or equal to about 0.45:1. In the semiconductor nanoparticle, the mole ratio of carbon to zinc may be less than or equal to about 1:1, less than or equal to about 0.9:1, less than or equal to about 0.7:1, or less than or equal to about 0.5:1.

In the semiconductor nanoparticle, a mole ratio of carbon to selenium may be greater than or equal to about 0.005:1, greater than or equal to about 0.01:1, greater than or equal to about 0.05:1, greater than or equal to about 0.1:1, greater than or equal to about 0.15:1, greater than or equal to about 0.2:1, greater than or equal to about 0.3:1, greater than or equal to about 0.4:1, greater than or equal to about 0.5:1, greater than or equal to about 0.7:1, greater than or equal to about 0.8:1, greater than or equal to about 0.9:1, or greater than or equal to about 0.95:1. In the semiconductor nanoparticle, the mole ratio of carbon to selenium may be less than or equal to about 2:1, less than or equal to about 1.5:1, less than or equal to about 1:1, less than or equal to about 0.9:1, less than or equal to about 0.7:1, or less than or equal to about 0.5:1.

In the semiconductor nanoparticle, a mole ratio of sulfur to selenium may be greater than or equal to about 0.4:1, greater than or equal to about 0.5:1, greater than or equal to about 0.6:1, greater than or equal to about 0.7:1, greater than or equal to about 0.8:1, or greater than or equal to about 0.9:1. In the semiconductor nanoparticle, the mole ratio of sulfur to selenium may be less than or equal to about 1:1, less than or equal to about 0.95:1, less than or equal to about 0.85:1, less than or equal to about 0.75:1, less than or equal to about 0.65:1, less than or equal to about 0.55:1, or less than or equal to about 0.45:1.

A mole amount of an element or a mole ratio among elements (for example, included in the semiconductor nanoparticle or the light emitting layer) as described herein may be determined through, e.g., with, an appropriate analysis tool (e.g., an inductively coupled plasma atomic emission spectroscopy (ICP-AES), an X-ray photoelectron spectroscopy (XPS), an ion chromatography, a transmission electron microscopy energy-dispersive X-ray spectroscopy (TEM-EDX), a scanning electron microscopy energy-dispersive X-ray spectroscopy (SEM-EDX), a X-ray fluorescence (XRF), or a combination thereof).

In an embodiment, the semiconductor nanoparticle may exhibit an average lifetime (or an average decay time) of greater than or equal to about 20 ns, greater than or equal to about 30 ns, greater than or equal to about 40 ns, greater than or equal to about 45 ns, or greater than or equal to about 50 ns in a time-resolved photoluminescence spectroscopy analysis. In the time-resolved photoluminescence spectroscopy analysis, the average lifetime (or average decay time) of the semiconductor nanoparticle may be less than or equal to about 500 ns, less than or equal to about 300 ns, less than or equal to about 100 ns, less than or equal to about 90 ns, less than or equal to about 80 ns, or less than or equal to about 75 ns.

The semiconductor nanoparticle may be synthesized by the method described herein.

A method of an embodiment may include synthesizing semiconductor nanocrystals of a few nanometers in size through a wet chemical process. In the wet chemical process, precursor materials are reacted in an organic solvent to form crystal particles, and the growth of the crystals may be controlled by the coordination of organic solvents or ligand compounds to the surface of the semiconductor nanocrystals. In an embodiment, the method for producing the semiconductor nanoparticle may include preparing a particle including a first semiconductor nanocrystal and optionally a second semiconductor nanocrystal.

Details of the first semiconductor nanocrystal and the second semiconductor nanocrystal are as described herein. In an embodiment of the method, if present, the second semiconductor nanocrystal may include zinc and selenium (e.g., a ZnSe, a ZnSeS, or a combination thereof). The second semiconductor nanocrystal may be disposed on the first semiconductor nanocrystal. The second semiconductor nanocrystal may be an intermediate shell layer of the semiconductor nanoparticle.

In an embodiment of the method, a preparation of the particle including the first semiconductor nanocrystal and optionally the second semiconductor nanocrystal is not particularly limited and may be appropriately selected.

In an embodiment, the first semiconductor nanocrystal or a core including the same may include zinc and selenium, and optionally tellurium. The first semiconductor nanocrystal or a core including the first semiconductor nanocrystal may include indium phosphide. In an embodiment, the first semiconductor nanocrystal or a core including the first semiconductor nanocrystal may include a ZnSe, a ZnSeTe, an InP, an InZnP, or a combination thereof. In an embodiment, the first semiconductor nanocrystal or a core including the first semiconductor nanocrystal may be produced by an appropriate method considering the composition and desired properties of the final nanoparticle, or may be commercially available.

In an embodiment, the first semiconductor nanocrystal or the core may include a zinc chalcogenide including zinc, selenium, and tellurium, and the first semiconductor nanocrystal or core may be obtained by preparing a zinc precursor solution including a zinc precursor and an organic ligand; preparing a selenium precursor and a tellurium precursor; heating the zinc precursor solution to a core formation reaction temperature, and adding the selenium precursor and the tellurium precursor optionally with an organic ligand and proceeding with the core formation reaction.

In an embodiment, the first semiconductor nanocrystal or a core including the first semiconductor nanocrystal may be formed by a hot injection method in which a solution including a metal precursor such as an indium precursor and optionally a ligand is heated to a high temperature (e.g., to a temperature of greater than or equal to about 200°C) and a phosphorus precursor is injected. In an embodiment, the core may be produced by a heating up method in which a phosphorus precursor is injected at a predetermined temperature and the temperature of the reaction system is raised.

In the core formation reaction, a ratio between the precursors (e.g., the molar ratio of selenium precursor to tellurium precursor) or the reaction time may be appropriately selected considering the emission wavelength of the final semiconductor nanoparticle, the reactivity of the precursors, and the reaction temperature. The core formation reaction temperature may be appropriately selected. The core formation reaction temperature may be greater than or equal to about 240°C, greater than or equal to about 250°C, greater than or equal to about 260°C, greater than or equal to about 270°C, greater than or equal to about 280°C, for example, greater than or equal to about 290°C. The reaction temperature for core formation may be in the range of about 280°C to about 340°C, for example, about 290°C to about 330°C, or about 300°C to about 320°C. The reaction time for core formation may be adjusted considering the desired core size and the reactivity of the precursors and is not particularly limited. For example, the reaction time may be greater than or equal to about 5 minutes, greater than or equal to about 30 minutes, or greater than or equal to about 50 minutes, but is not limited thereto. For example, the reaction time may be less than or equal to about 2 hours, but is not limited thereto. The formed core may be separated from the reaction system (e.g., by nonsolvent precipitation) or may not be separated. The separated core may be washed, if desired, and added to subsequent reactions.

The semiconductor nanoparticle of an embodiment may further include a second semiconductor nanocrystal or an intermediate shell layer including the second semiconductor nanocrystal, and the method of forming the second semiconductor nanocrystal or the intermediate shell layer including the second semiconductor nanocrystal is not particularly limited and may be appropriately selected.

In an embodiment of the method, the forming of the second semiconductor nanocrystal (or intermediate shell layer including the same) on the first semiconductor nanocrystal may include mixing (reacting) a zinc precursor with a chalcogen precursor (e.g., a selenium precursor and optionally a sulfur precursor) in the presence of an organic solvent and the first semiconductor nanocrystal at a reaction temperature.

The organic ligand, the organic solvent, and the precursors are not particularly limited and may be appropriately selected.

The organic solvent may include a C6-C22 primary amine such as a hexadecylamine, a C6-C22 secondary amine such as dioctylamine, a C6-C40 tertiary amine such as a trioctyl amine, a nitrogen-containing heterocyclic compound such as pyridine, a C6-C40 olefin such as octadecene, a C6-C40 aliphatic hydrocarbon such as hexadecane, octadecane, or squalane, an aromatic hydrocarbon substituted with a C6-C30 alkyl group such as phenyldodecane, phenyltetradecane, or phenyl hexadecane, a primary, secondary, or tertiary phosphine (e.g., trioctyl phosphine ) substituted with at least one (e.g., 1, 2, or 3) C6-C22 alkyl group, a phosphine oxide (e.g. trioctylphosphine oxide) substituted with a (e.g., 1, 2, or 3) C6-C22 alkyl group, a C12-C22 aromatic ether such as phenyl ether or benzyl ether, or a combination thereof.

The organic ligand may coordinate the surfaces of the prepared semiconductor nanoparticles and allow the semiconductor nanoparticles to be well dispersed in the solution. The organic ligand may include RCOOH, RNH₂, R₂NH, R₃N, RSH, RH₂PO, R₂HPO, RsPO, RH₂P, R₂HP, R₃P, ROH, RCOOR', RPO(OH)₂, R₂POOH (wherein R and R' independently include substituted or unsubstituted C1 or more, C6 or more, or C10 or more and C40 or less, C35 or less, or C25 or less aliphatic hydrocarbon group, or substituted or unsubstituted C6-C40 aromatic hydrocarbon group, or a combination thereof), or a combination thereof. The ligands may be used alone or as a combination of two or more compounds.

A type of the indium precursor is not particularly limited and may be selected appropriately. The indium precursor may include an indium powder, an alkylated indium compound, an indium alkoxide, an indium carboxylate, an indium nitrate, an indium perchlorate, an indium sulfate, an indium acetylacetonate, an indium halide, an indium cyanide, an indium hydroxide, an indium oxide, an indium peroxide, an indium carbonate, an indium acetate, or a combination thereof. The indium precursor may include an indium carboxylate such as indium oleate and indium myristate, an indium acetate, an indium hydroxide, an indium chloride, an indium bromide, an indium iodide, or a combination thereof.

A type of a phosphorus precursor is not particularly limited and may be appropriately selected. The phosphorus precursor may include tris(trimethylsilyl) phosphine, tris(dimethylamino) phosphine, triethylphosphine, tributylphosphine, trioctylphosphine, triphenylphosphine, tricyclohexylphosphine, dimethylaminophosphine, diethylaminophosphine, or a combination thereof.

Examples of the organic ligand may include methane thiol, ethane thiol, propane thiol, butane thiol, pentane thiol, hexane thiol, heptane thiol, octane thiol, nonanethiol, decanethiol, dodecane thiol, hexadecane thiol, octadecane thiol, benzyl thiol; methyl amine, ethyl amine, propyl amine, butyl amine, pentyl amine, hexyl amine, octyl amine, dodecyl amine, hexadecyl amine, octadecyl amine, dimethyl amine, diethyl amine, dipropyl amine; methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, benzoic acid; substituted or unsubstituted methyl phosphine (e.g., trimethyl phosphine, methyldiphenyl phosphine, or the like), substituted or unsubstituted ethyl phosphine (e.g., triethyl phosphine, ethyldiphenyl phosphine, or the like), substituted or unsubstituted propyl phosphine, substituted or unsubstituted butyl phosphine, substituted or unsubstituted pentyl phosphine, substituted or unsubstituted octylphosphine (e.g., trioctylphosphine (TOP)), or the like; a phosphine oxide such as substituted or unsubstituted methyl phosphine oxide (e.g., trimethyl phosphine oxide, methyldiphenylphosphine oxide, or the like), substituted or unsubstituted ethyl phosphine oxide (e.g., triethyl phosphine oxide, ethyldiphenyl phosphine oxide, or the like), substituted or unsubstituted propyl phosphine oxide, substituted or unsubstituted butyl phosphine oxide, substituted or unsubstituted octylphosphine oxide (e.g., trioctylphosphine oxide (TOPO), or the like); diphenyl phosphine, a triphenyl phosphine, or an oxide compound thereof; a C5-C20 alkylphosphinic acid such as hexylphosphinic acid, octylphosphinic acid, dodecanephosphinic acid, tetradecanephosphinic acid, hexadecanephosphinic acid, or octadecanephosphinic acid; a C5-C20 alkyl phosphonic acid; or the like, but embodiments are not limited thereto. The organic ligand may be used alone or as a combination of two or more.

The zinc precursor may be a Zn metal powder, ZnO, an alkylated Zn compound (e.g., a C2-C30 dialkyl zinc such as diethyl zinc), a Zn alkoxide (e.g., a zinc ethoxide), a Zn carboxylate (e.g., a zinc acetate), a Zn nitrate, a Zn perchlorate, a Zn sulfate, Zn acetylacetonate, a Zn halide (e.g., a zinc chloride), a Zn cyanide, a Zn hydroxide, a Zn carbonate, a Zn peroxide, or a combination thereof. Examples of the zinc precursor may be dimethyl zinc, diethyl zinc, zinc acetate, zinc acetylacetonate, zinc iodide, zinc bromide, zinc chloride, zinc fluoride, zinc carbonate, zinc cyanide, zinc nitrate, zinc oxide, zinc peroxide, zinc perchlorate, zinc sulfate, or a combination thereof.

The selenium precursor may include selenium-trioctylphosphine ("Se-TOP"), selenium-tributylphosphine ("Se-TBP"), selenium-triphenylphosphine ("Se-TPP"), selenium-diphenylphosphine ("Se-DPP"), or a combination thereof, but is not limited thereto.

The tellurium precursor may include tellurium-tributylphosphine ("Te-TBP"), tellurium-triphenylphosphine ("Te-TPP"), tellurium-diphenylphosphine ("Te-DPP"), or a combination thereof, but is not limited thereto.

The sulfur precursor may be hexane thiol, octane thiol, decane thiol, dodecane thiol, hexadecane thiol, mercapto propyl silane, sulfur-trioctylphosphine ("S-TOP"), sulfur-tributylphosphine ("S-TBP"), sulfur-triphenylphosphine ("S-TPP"), sulfur-trioctylamine ("S-TOA"), a bis(trialkylsilyl) sulfide, a bis(trialkylsilylalkyl) sulfide e.g., bis(trimethylsilylmethyl) sulfide, ammonium sulfide, sodium sulfide, or a combination thereof.

The particle including a first semiconductor nanocrystal and, optionally, a second semiconductor nanocrystal may be separated and washed in a manner described herein prior to being subjected to a subsequent reaction (e.g., a formation reaction of a semiconductor nanocrystal shell containing zinc and sulfur). The separated and washed particle may be dispersed in an appropriate organic solvent (e.g., an aromatic solvent such as toluene or an aliphatic hydrocarbon solvent such as octane) and added to a subsequent reaction.

In an embodiment, the method for producing the semiconductor nanoparticle may include contacting (e.g., reacting) a zinc precursor (e.g., a zinc carboxylate) and a sulfur precursor in a reaction medium containing an organic solvent in the presence of the particle including the first semiconductor nanocrystal and, optionally, the second semiconductor nanocrystal; and adding a metal halide to the reaction medium.

The shell layer containing zinc and sulfur may be formed on the particle by the reaction. The zinc precursor (a zinc carboxylate) may include a first zinc precursor (e.g., a first zinc carboxylate) including a first organic ligand and zinc ions and a second zinc precursor (e.g., a second zinc carboxylate) including a second organic ligand and a zinc ion. Details of the first organic ligand, the second organic ligand, the organic solvent, and the sulfur precursor are as described herein. The sulfur precursor used for forming the ZnS shell layer is as described herein. In an embodiment, the sulfur precursor may include a thiol compound (e.g., a monothiol compound having an alkyl group of C1-C30, C5-C24, or C8-C12, such as dodecanethiol).

In the semiconductor nanocrystal shell, the conventional synthesis method for providing a zinc sulfide-based shell layer (e.g., an outermost shell layer) have utilized a zinc carboxylate (e.g., zinc oleate) having a relatively long organic chain. The present inventors have found that such a long-chain zinc carboxylate has a relatively slow reaction rate, making it difficult to provide a desired quality (uniform) ZnS shell. Additionally, a long-chain carboxylate derived from the zinc precursor may be included as a long-chain ligand on the surface of a resulting semiconductor nanoparticle, which may not have an adverse effect the luminescence efficiency in solution state or photoluminescent type devices, but can act as an insulator in a electroluminescent device to hinder charge injection and to cause device performance degradation. For reducing the organic content, it is possible to consider modifying a surface of the semiconductor nanoparticle with a metal halide (e.g., zinc chloride). However, the inventors have found that a resulting semiconductor nanoparticle obtained from such a modification may not exhibit a desired level of dispersibility in an organic solvent, and thus there has still remained technical difficulties in forming a light-emitting layer of an electroluminescent device via a solution process.

Surprisingly, the inventors have found that the semiconductor nanoparticle produced by the method described herein, in forming the shell layer including zinc and sulfur, can exhibit a desired dispersibility for a subsequent light-emitting layer formation process and the light emitting layer including the semiconductor nanoparticle can contribute to an improved property and a prolonged lifespan for a resulting electroluminescent device.

Without wishing to be bound by any theory, the zinc precursor (e.g., the second zinc precursor) having a long-chain carboxylate can show a significant difference in pKa compared to the first zinc precursor, and the combination of these zinc precursors can contribute to the uniform growth of the zinc sulfide (ZnS) shell layer. Additionally, it is believed that the combination can optimize a total organic content of the ligand system placed in the outermost layer of the semiconductor nanoparticle, thereby an improved property during the operation of the electroluminescent device may be achieved and a device degradation may be prevented effectively to realize an extended lifespan.

The first zinc precursor may include a first organic ligand and a zinc ion, which may be obtained by a reaction between a carboxylic acid corresponding to the first organic ligand (hereinafter, the first carboxylic acid) and an appropriate zinc compound (e.g., zinc acetate). The second zinc precursor may include a second organic ligand and a zinc ion, which may be obtained by a reaction between a carboxylic acid corresponding to the second organic ligand (hereinafter, the second carboxylic acid) and an appropriate zinc compound (e.g., zinc acetate). The appropriate zinc compound may include the zinc precursor described herein, for example, for the synthesis of the core and the ZnSe shell layer formation. Details of the first organic ligand and the second organic ligand are as described herein.

The first carboxylic acid is a carboxylic acid containing the first organic ligand. In an embodiment, the first carboxylic acid may be represented by the following chemical formula 2:

Chemical Formula 2 **R-(CR₂)ₙ-COOH**

wherein the definitions of R and n are the same as in Chemical Formula 1.

The first carboxylic acid may have a pKa of greater than or equal to about 4.8, greater than or equal to about 4.9, greater than or equal to about 5.5, greater than or equal to about 5.8, greater than or equal to about 6.5, or greater than or equal to about 7. The first carboxylic acid may have a pKa that is lower than that of the second carboxylic acid. In an embodiment, the first carboxylic acid may have a pKa of less than or equal to about 9, less than or equal to about 8.8, less than or equal to about 8.3, less than or equal to about 7.5, less than or equal to about 6.7, less than or equal to about 5.8, or less than or equal to about 4.9.

The first carboxylic acid may include propanoic acid, pentanoic acid, hexanoic acid, octanoic acid, ethylhexanoic acid, nonanoic acid, decanoic acid, dodecanoic acid, myristic acid, palmitic acid, ethyl butyric acid, propylvaleric acid, methyl butyric acid, butyloctanoic acid, or a combination thereof.

The second carboxylic acid is a carboxylic acid containing the second organic ligand as described above. In an embodiment, the second organic ligand may include linolenic acid, linoleic acid, oleic acid, elaidic acid, stearic acid, myristic acid, palmitic acid, or a combination thereof.

The second carboxylic acid may have a pKa of greater than or equal to about 8.9, greater than or equal to about 9, greater than or equal to about 9.1, greater than or equal to about 9.8, greater than or equal to about 10, greater than or equal to about 10.1, or greater than or equal to about 10.14.

In an embodiment, the first zinc precursor may have the following structure, but is not limited thereto:

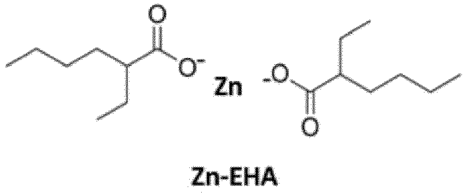

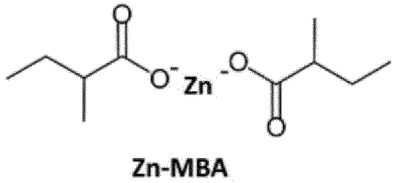

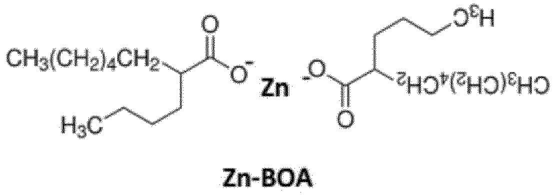

In an embodiment, the second zinc precursor may have the following structure, but is not limited thereto:

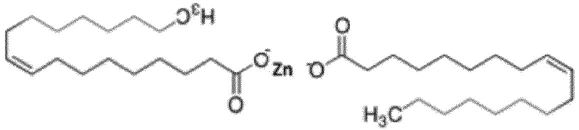

The metal halide can include a zinc halide, an aluminum halide, or a combination thereof. The zinc halide can include zinc chloride, zinc fluoride, zinc bromide, zinc iodide, or a combination thereof. The aluminum halide can include aluminum chloride, aluminum bromide, aluminum fluoride, aluminum iodide, or a combination thereof.

In an embodiment, a reaction medium containing an organic solvent and, optionally, an organic ligand may be vacuum-treated. The organic ligand is as described herein. The vacuum treatment can include heating (or vacuum-treating) the solvent and, optionally, the ligand compound to a predetermined temperature (e.g., greater than or equal to about 100°C) under vacuum. The vacuum-treated reaction medium may be replaced with an inert gas atmosphere and heated again to a predetermined temperature (e.g., greater than or equal to about 120°C or the reaction temperature).

In an embodiment, the particle and the sulfur precursor may be added to the reaction medium heated to the predetermined temperature. In an embodiment, the first zinc precursor may be added to the reaction medium (once, twice, or more than twice) and contacted with the sulfur precursor, and then the second zinc precursor may be added to the reaction medium and contacted with the sulfur precursor. In an embodiment, the second zinc precursor may be added to the reaction medium (once, twice, or more than twice) and contacted with the sulfur precursor first, and then the first zinc precursor may be added to the reaction medium and contacted with the sulfur precursor.

The first zinc precursor may be added to the reaction medium more than once (e.g., two times or greater) in a predetermined aliquot. The second zinc precursor may be added to the reaction medium more than once (e.g., two times or greater) in a predetermined aliquot.

In an embodiment, after the first zinc precursor (or the second zinc precursor) has contacted with the sulfur precursor, the metal halide can be added to the reaction medium.

In an embodiment, the first zinc precursor can contact the sulfur precursor first, and then the second zinc precursor can contact the sulfur precursor. The second zinc precursor may be added to the reaction medium before, simultaneously with, or after the addition of the metal halide. In an embodiment, the second zinc precursor can contact the sulfur precursor first, and then the first zinc precursor can contact the sulfur precursor. The first zinc precursor may be added to the reaction medium before, simultaneously with, or after the addition of the metal halide.

In an embodiment, an amount of the second zinc precursor relative to 1 mole of the first zinc precursor can be greater than or equal to about 0.01 moles, greater than or equal to about 0.03 moles, greater than or equal to about 0.05 moles, greater than or equal to about 0.07 moles, greater than or equal to about 0.09 moles, greater than or equal to about 0.1 mole, greater than or equal to about 0.2 moles, greater than or equal to about 0.3 moles, greater than or equal to about 0.4 moles, greater than or equal to about 0.5 moles, greater than or equal to about 0.6 moles, greater than or equal to about 0.7 moles, greater than or equal to about 0.8 moles, greater than or equal to about 0.9 moles, greater than or equal to about 1 mole, greater than or equal to about 1.2 moles, greater than or equal to about 1.5 moles, greater than or equal to about 1.7 moles, greater than or equal to about 1.9 moles, greater than or equal to about 2 moles, greater than or equal to about 2.1 moles, greater than or equal to about 2.3 moles, greater than or equal to about 2.5 moles, greater than or equal to about 2.7 moles, greater than or equal to about 2.9 moles, greater than or equal to about 3 moles, greater than or equal to about 3.5 moles, greater than or equal to about 4 moles, greater than or equal to about 4.5 moles, greater than or equal to about 5 moles, greater than or equal to about 5.5 moles, greater than or equal to about 6 moles, greater than or equal to about 6.5 moles, greater than or equal to about 7 moles, greater than or equal to about 7.5 moles, greater than or equal to about 8 moles, greater than or equal to about 8.5 moles, greater than or equal to about 9 moles, greater than or equal to about 9.5 moles, greater than or equal to about 10 moles, greater than or equal to about 50 moles, or greater than or equal to about 100 moles.

In an embodiment, the amount of the second zinc precursor relative to 1 mole of the first zinc precursor can be less than or equal to about 100 moles, less than or equal to about 90 moles, less than or equal to about 80 moles, less than or equal to about 70 moles, less than or equal to about 60 moles, less than or equal to about 50 moles, less than or equal to about 40 moles, less than or equal to about 30 moles, less than or equal to about 20 moles, less than or equal to about 10 moles, less than or equal to about 9 moles, less than or equal to about 8 moles, less than or equal to about 7 moles, less than or equal to about 6 moles, less than or equal to about 5 moles, less than or equal to about 4 moles, less than or equal to about 3 moles, less than or equal to about 2 moles, less than or equal to about 1 mole, less than or equal to about 0.8 moles, less than or equal to about 0.6 moles, less than or equal to about 0.4 moles, less than or equal to about 0.3 moles, less than or equal to about 0.2 moles, less than or equal to about 0.06 moles, or less than or equal to about 0.03 moles.

In an embodiment, an amount of the metal halide relative to 1 mole of the total zinc precursor (i.e., the sum of the first zinc precursor and the second zinc precursor) can be greater than or equal to about 0.01 moles, greater than or equal to about 0.03 moles, greater than or equal to about 0.04 moles, greater than or equal to about 0.05 moles, greater than or equal to about 0.07 moles, greater than or equal to about 0.09 moles, greater than or equal to about 0.1 mole, greater than or equal to about 0.12 moles, greater than or equal to about 0.14 moles, greater than or equal to about 0.16 moles, greater than or equal to about 0.18 moles, greater than or equal to about 0.2 moles, greater than or equal to about 0.21 moles, greater than or equal to about 0.23 moles, greater than or equal to about 0.25 moles, greater than or equal to about 0.27 moles, greater than or equal to about 0.29 moles, greater than or equal to about 0.3 moles, greater than or equal to about 0.35 moles, greater than or equal to about 0.4 moles, greater than or equal to about 0.45 moles, greater than or equal to about 0.5 moles, greater than or equal to about 0.55 moles, greater than or equal to about 0.6 moles, greater than or equal to about 0.65 moles, greater than or equal to about 0.7 moles, greater than or equal to about 0.75 moles, greater than or equal to about 0.8 moles, greater than or equal to about 0.85 moles, greater than or equal to about 0.9 moles, greater than or equal to about 0.95 moles, greater than or equal to about 1 mole, greater than or equal to about 5 moles, greater than or equal to about 10 moles, greater than or equal to about 50 moles, or greater than or equal to about 100 moles.

In an embodiment, the amount of the metal halide relative to 1 mole of the total zinc precursor can be less than or equal to about 100 moles, less than or equal to about 90 moles, less than or equal to about 80 moles, less than or equal to about 70 moles, less than or equal to about 40 moles, less than or equal to about 10 moles, less than or equal to about 3 moles, less than or equal to about 1 mole, less than or equal to about 0.96 moles, less than or equal to about 0.84 moles, less than or equal to about 0.72 moles, less than or equal to about 0.63 moles, less than or equal to about 0.58 moles, less than or equal to about 0.52 moles, less than or equal to about 0.49 moles, less than or equal to about 0.43 moles, less than or equal to about 0.41 moles, less than or equal to about 0.4 moles, less than or equal to about 0.38 moles, less than or equal to about 0.34 moles, less than or equal to about 0.28 moles, less than or equal to about 0.26 moles, less than or equal to about 0.24 moles, less than or equal to about 0.22 moles, less than or equal to about 0.2 moles, less than or equal to about 0.19 moles, less than or equal to about 0.17 moles, less than or equal to about 0.15 moles, less than or equal to about 0.13 moles, less than or equal to about 0.11 moles, less than or equal to about 0.08 moles, less than or equal to about 0.06 moles, or less than or equal to about 0.03 moles.

The predetermined temperature or the reaction temperature can be appropriately selected. In an embodiment, the vacuum-treated reaction medium can be heated to a first temperature, and the first semiconductor nanocrystal, the first zinc precursor (or the second zinc precursor), and the sulfur precursor can be added, and then the reaction medium can be raised to the reaction temperature. The first temperature can be lower than the reaction temperature. The difference between the first temperature and the reaction temperature can be in the range of about 80°C to about 250°C, about 80°C to about 200°C, about 120°C to about 180°C, about 140°C to about 160°C, or a combination thereof.

The reaction temperature can be greater than or equal to about 250°C, greater than or equal to about 260°C, greater than or equal to about 270°C, greater than or equal to about 280°C, greater than or equal to about 300°C, greater than or equal to about 320°C, greater than or equal to about 340°C, or greater than or equal to about 350°C. The reaction temperature can be less than or equal to about 400°C, less than or equal to about 390°C, less than or equal to about 380°C, less than or equal to about 370°C, less than or equal to about 360°C, less than or equal to about 350°C, less than or equal to about 345°C, less than or equal to about 340°C, less than or equal to about 330°C, less than or equal to about 320°C, less than or equal to about 310°C, less than or equal to about 290°C, less than or equal to about 280°C, less than or equal to about 270°C, or less than or equal to about 250°C. In an embodiment, the reaction temperature can vary in the range of about 340°C to about 250°C.

The reaction time can be appropriately selected considering the type of precursor, reaction temperature, desired thickness of the ZnS shell layer in the final semiconductor nanoparticle, and the like. The reaction time can be greater than or equal to about 10 minutes, greater than or equal to about 15 minutes, greater than or equal to about 20 minutes, greater than or equal to about 25 minutes, greater than or equal to about 30 minutes, greater than or equal to about 35 minutes, or greater than or equal to about 40 minutes. The reaction time can be less than or equal to about 3 hours, less than or equal to about 2 hours, less than or equal to about 200 minutes, less than or equal to about 180 minutes, less than or equal to about 160 minutes, less than or equal to about 140 minutes, less than or equal to about 120 minutes, less than or equal to about 100 minutes, less than or equal to about 90 minutes, or less than or equal to about 80 minutes.

After the reaction is completed, the particle inlcuding the first semiconductor nanocrystal or the second semiconductor nanocrystal, or the obtained semiconductor nanoparticle, can be recovered by pouring an excess of a non-solvent to remove excess organic material not coordinated on the surface, and then centrifuging the resulting mixture. For example, after the reaction is completed, adding a non-solvent to the reaction product can separate the semiconductor nanoparticles coordinated with the ligand compound. The non-solvent can be a polar solvent that is miscible with the solvent used in the core formation and/or shell formation reaction but cannot disperse the manufactured nanocrystal. The non-solvent can be determined according to the solvent used in the reaction and can include, for example, acetone, ethanol, butanol, isopropanol, water, tetrahydrofuran (THF), dimethyl sulfoxide (DMSO), diethyl ether, formaldehyde, acetaldehyde, ethylene glycol, a solvent having a similar solubility parameter to the non-solvents listed above, or a combination thereof, but is not limited thereto. The separation can be performed using centrifugation, precipitation, chromatography, or distillation. The separated nanocrystal can be washed by adding it to a washing solvent as desired. The washing solvent is not particularly limited and can be a solvent having a similar solubility parameter to the ligand, examples of which include hexane, heptane, octane, chloroform, toluene, benzene, and the like.

The semiconductor nanoparticle of an embodiment may not be dispersible in water, any of the foregoing listed non-solvents, or a mixture thereof. The semiconductor nanoparticle of an embodiment may be water-insoluble. The semiconductor nanoparticle of an embodiment may be dispersed in the aforementioned organic solvent. In an embodiment, the semiconductor nanoparticles may be dispersed in a C6-C40 aliphatic hydrocarbon, a C6-C40 aromatic hydrocarbon, or a mixture thereof.

The obtained semiconductor nanoparticle can exhibit the properties described herein.

In an embodiment, the semiconductor nanoparticle can form a composition (ink) for an inkjet printing process and can provide a light-emitting layer pattern through the inkjet printing process. A composition for the inkjet process can include the semiconductor nanoparticle of an embodiment and a liquid vehicle. The semiconductor nanoparticle of an embodiment can form a colloidal dispersion in the liquid vehicle. At least a portion of the liquid vehicle can be removed from the light-emitting layer after the inkjet process. The liquid vehicle can include an organic solvent. The organic solvent can include the dispersion solvent described herein. The organic solvent can be an organic solvent having a relatively high boiling point at atmospheric or ambient pressure. The boiling point of the organic solvent or the liquid vehicle can be greater than or equal to about 120°C, greater than or equal to about 130°C, greater than or equal to about 140°C, greater than or equal to about 150°C, greater than or equal to about 160°C, greater than or equal to about 170°C, or greater than or equal to about 180°C. The boiling point of the organic solvent can be less than or equal to about 300°C, less than or equal to about 280°C, less than or equal to about 270°C, less than or equal to about 250°C, or less than or equal to about 200°C. The organic solvent can include a substituted or unsubstituted aromatic solvent such as cyclohexylbenzene, a substituted or unsubstituted C6-C15 aliphatic hydrocarbon solvent such as hexane, octane, or decane, or a combination thereof. When using a mixed solvent, the mixing ratio can be adjusted in consideration of conditions for the inkjet process (e.g., boiling point, viscosity). For example, when using a mixed solvent of an aromatic solvent and an aliphatic solvent, the ratio can be adjusted to 1:0.1 to 1:10, 1:0.3 to 1:3, or 1:0.5 to 1:2 (volume:volume), but is not limited thereto.

The semiconductor nanoparticle may be included in the ink composition by having the properties described herein, contributing to the composition exhibiting an appropriate viscosity. The viscosity may be in the range of about 0.5 centipoise (cPs) to about 30 cPs, about 1 cPs to about 15 cPs, about 1.5 cPs to about 10 cPs, about 2 cPs to about 8 cPs, about 2.5 cPs to about 5 cPs, about 2.8 cPs to about 3.5 cPs, or a combination thereof.

The composition for inkjet printing may exhibit surface tension or wettability with respect to a common layer, for example, a hole auxiliary layer or an electron auxiliary layer. The surface tension may be in the range of about 10 milliNewtons per meter (mN/m) to about 100 mN/m, about 15 mN/m to about 80 mN/m, about 20 mN/m to about 50 mN/m, about 25 mN/m to about 45 mN/m, about 30 mN/m to about 40 mN/m, about 33 mN/m to about 38 mN/m, or a combination thereof.

Forming the light-emitting layer by an inkjet printing manner may include putting or accommodating the ink composition containing the semiconductor nanoparticle in equipment equipped with an inkjet printing nozzle, and ejecting/depositing droplets of the composition from the nozzle toward a desired location (e.g., a hole transport layer or electron transport layer surface defined by a partition wall or bank such as a pixel defining layer (PDL)). (See FIG. 4 and FIG. 5.)

In an electroluminescent device of an embodiment, a thickness of the light emitting layer may be selected appropriately. In an embodiment, the light emitting layer 3 or 30 may include a monolayer of semiconductor nanoparticles. In an embodiment, the light emitting layer 3 or 30 may include a monolayer of semiconductor nanoparticles, e.g., one or more, two or more, three or more, or four or more and 20 or less, 10 or less, 9 or less, 8 or less, 7 or less, or 6 or less, monolayers of semiconductor nanoparticles. The light emitting layer 3 or 30 may have a thickness of greater than or equal to about 5 nm, for example, greater than or equal to about 10 nm, greater than or equal to about 20 nm, or greater than or equal to about 30 nm and less than or equal to about 200 nm, for example, less than or equal to about 150 nm, less than or equal to about 100 nm, less than or equal to about 90 nm, less than or equal to about 80 nm, less than or equal to about 70 nm, less than or equal to about 60 nm, or less than or equal to about 50 nm. The light emitting layer 3 or 30 may have a thickness of, for example, about 10 nm to about 150 nm, about 20 nm to about 100 nm, about 30 nm to about 50 nm, or a combination thereof.

The formation of the light emitting layer may be performed by preparing a composition including nanostructures (configured to emit a desired light) and applying or depositing the composition on a substrate, for example, including an electrode or a charge auxiliary layer in, e.g., by, an appropriate method (e.g., spin coating, inkjet printing, and the like).

The forming of the light-emitting layer may further include heat-treating the coated or deposited semiconductor nanoparticle layer. The heat-treating (e.g., thermal treatment, or heat treatment) temperature is not particularly limited, and it can be appropriately selected taking into consideration the boiling point of the organic solvent. For example, the heat treatment temperature may be greater than or equal to about 60°C, or greater than or equal to about 70 °C, and less than or equal to about 250 °C, or less than or equal to about 180 °C. A type of the organic solvent for the coating liquid is not particularly limited and may be selected appropriately. In an embodiment, the organic solvent may include a substituted or unsubstituted aliphatic hydrocarbon organic solvent, a substituted or unsubstituted aromatic hydrocarbon solvent, a substituted or unsubstituted alicyclic hydrocarbon solvent, an acetate solvent, or a combination thereof.

In an embodiment, the light-emitting layer may be a single layer or a multi-layered structure having at least two layers. In the multi-layered structure, adjacent layers (e.g., a first light-emitting layer and a second light-emitting layer) may be configured to emit a first light (e.g., green light, blue light, or red light). In the multi-layered structure, adjacent layers (e.g., a first light-emitting layer and a second light-emitting layer) may have the same or different composition, ligands, or a combination thereof. In an embodiment, the (multi-layered) light-emitting layer may have a halogen amount that varies (increase or decrease) in a thickness direction. In an embodiment, in the (multi-layered) light-emitting layer, the amount of the halogen may increase in a direction toward the electron auxiliary layer. In the (multi-layered) light-emitting layer, an amount, or a content of an organic ligand may decrease in the direction toward the electron auxiliary layer. In the (multi-layered) light-emitting layer, the amount, or the content of the organic ligand may increase in the direction toward the electron auxiliary layer.

The electroluminescent device may further include a charge (hole or electron) auxiliary layer between the first electrode and the second electrode (e.g., an anode and a cathode). In an embodiment, the electroluminescent device may include a hole auxiliary layer 20 or an electron auxiliary layer 40 between the anode 10 and the light emitting layer 30, between the cathode 50 and the light emitting layer 30, or a combination thereof. (See FIGS. 2 and 3.)

The light emitting device according to an embodiment may further include a hole auxiliary layer. The hole auxiliary layer 20 may be disposed between the first electrode 10 and the light emitting layer 30. The hole auxiliary layer 20 may include a hole injection layer, a hole transport layer, an electron blocking layer, or a combination thereof. The hole auxiliary layer 20 may be a layer of a single component or a multilayer structure in which adjacent layers include different components.

The hole auxiliary layer 20 may have a HOMO energy level that may be matched with the HOMO energy level of the light emitting layer 30 in order to enhance mobility of holes transferred from the hole auxiliary layer 20 to the light emitting layer 30. In an embodiment, the hole auxiliary layer 20 may include a hole injection layer close to the first electrode 10 and a hole transport layer close to the light emitting layer 30.

The material included in the hole auxiliary layer 20 (e.g., a hole transport layer, a hole injection layer, or an electron blocking layer) is not particularly limited, and may include, for example, poly(9,9-dioctyl-fluorene-co-N-(4-butylphenyl)-diphenylamine) ("TFB"), polyarylamine, poly(N-vinylcarbazole), poly(3,4-ethylenedioxythiophene) ('PEDOT"), poly(3,4-ethylenedioxythiophene):polystyrene sulfonate ("PEDOT:PSS"), polyaniline, polypyrrole, N,N,N',N'-tetrakis(4-methoxyphenyl)-benzidine ("TPD"), 4,4'-bis[N-(1-naphthyl)-N-phenyl-amino]biphenyl ("α-NPD"), 4,4',4"-Tris[phenyl(m-tolyl)amino]triphenylamine (m-MTDATA), 4,4',4"-tris(N-carbazolyl)-triphenylamine ("TCTA"), 1,1-bis[(di-4-toylamino)phenyl]cyclohexane ("TAPC"), a p-type metal oxide (e.g., NiO, WOs, MoOs, etc.), a carbon-based material such as graphene oxide, or a combination thereof, but is not limited thereto.

In the hole auxiliary layer(s), the thickness of each layer may be appropriately selected. For example, the thickness of each layer may be greater than or equal to about 5 nm, greater than or equal to about 10 nm, greater than or equal to about 15 nm, or greater than or equal to about 20 nm and less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 35 nm, or less than or equal to about 30 nm, but is not limited thereto.

The electron auxiliary layer 40 may be disposed between the light emitting layer 30 and the second electrode 50. The electron auxiliary layer 40 may include, for example, an electron injection layer, an electron transport layer, a hole blocking layer, or a combination thereof. The electron auxiliary layer may include, for example, an electron injection layer ("EIL") that facilitates injection of electrons, an electron transport layer ("ETL") that facilitates transport of electrons, a hole blocking layer ("HBL") that blocks the movement of holes, or a combination thereof.

In an embodiment, the electron injection layer may be disposed between the electron transport layer and the cathode. For example, the hole blocking layer may be disposed between the light emitting layer and the electron transport (injection) layer but is not limited thereto. The thickness of each layer may be selected appropriately. For example, the thickness of each layer may be greater than or equal to about 1 nm and less than or equal to about 500 nm, but is not limited thereto. The electron injection layer may be an organic layer formed by vapor deposition. The electron transport layer may include an inorganic oxide nanoparticle or may be an organic layer formed by vapor deposition.

The electron transport layer ("ETL"), the electron injection layer, the hole blocking layer, or a combination thereof may include, for example, 1,4,5,8-naphthalenetetracarboxylic dianhydride ("NTCDA"), bathocuproine ("BCP"), tris[3-(3-pyridyl)-mesityl]borane ("3TPYMB"), LiF, tris(8-hydroxyquinoline)aluminum ("Alq₃"), tris(8-hydroxyquinoline)gallium ("Gaq₃"), tris-(8-hydroxyquinoline)indium ("Inq₃"), bis(8-hydroxyquinoline)zinc ("Znq₂"), bis(2-(2-hydroxyphenyl)benzothiazolate)zinc ("Zn(BTZ)₂"), bis(10-hydroxybenzo[h]quinolinato)beryllium ("BeBq₂"), 8-(4-(4,6-di(naphthalen-2-yl)-1,3,5-triazin-2-yl)phenyl)quinolone ("ET204"), 8-hydroxyquinolinato lithium ("Liq"), an n-type metal oxide (e.g., ZnO, HfO₂, etc.) or a combination thereof, but is not limited thereto.

The electron auxiliary layer 40 may include an electron transport layer. The electron transport layer may include a plurality of nanoparticles. The plurality of nanoparticles may include a metal oxide containing zinc.

The metal oxide may include zinc oxide, zinc magnesium oxide, or a combination thereof. The metal oxide may include Zn₁₋ₓMₓO, wherein M is Mg, Ca, Zr, W, Li, Ti, Y, Al, or a combination thereof and 0 ≤ x ≤ 0.5. In an embodiment, the M in the formula Zn₁₋ₓ MₓO may be magnesium (Mg). In an embodiment, in the formula Zn₁₋ₓMₓO, the x may be greater than or equal to about 0.01 and less than or equal to about 0.3, for example, less than or equal to about 0.25, less than or equal to about 0.2, or less than or equal to about 0.15.

The absolute value of the LUMO of the aforementioned nanostructures included in the light emitting layer may be greater or smaller than the absolute value of the LUMO of the metal oxide. The average size of the nanoparticles may be greater than or equal to about 1 nm, for example, greater than or equal to about 1.5 nm, greater than or equal to about 2 nm, greater than or equal to about 2.5 nm, or greater than or equal to about 3 nm and less than or equal to about 10 nm, less than or equal to about 9 nm, less than or equal to about 8 nm, less than or equal to about 7 nm, less than or equal to about 6 nm, or less than or equal to about 5 nm.

In an embodiment, each thickness of the electron auxiliary layer 40 (e.g., electron injection layer, electron transport layer, or hole blocking layer) may be greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, or greater than or equal to about 20 nm, and less than or equal to about 120 nm, less than or equal to about 110 nm, less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 30 nm, or less than or equal to about 25 nm, but is not limited thereto.

A device according to an embodiment may have a normal structure. In an embodiment, in the device, the anode 10 disposed on the transparent substrate 100 may include a metal oxide-based transparent electrode (e.g., an ITO electrode), and the cathode 50 facing the anode 10 may include a conductive metal (e.g., having a relatively low work function, such as Mg, Al, etc.). The hole auxiliary layer 20 (e.g., a hole injection layer such as PEDOT:PSS, p-type metal oxide, or a combination thereof; a hole transport layer such as TFB, polyvinylcarbazole ("PVK"), or a combination thereof; or a combination thereof) may be provided between the transparent electrode 10 and the light emitting layer 30. The hole injection layer may be disposed close to the transparent electrode and the hole transport layer may be disposed close to the light emitting layer. The electron auxiliary layer 40 such as an electron injection/transport layer may be disposed between the light emitting layer 30 and the cathode 50. (See FIG. 2.)

A device according to an embodiment may have an inverted structure. Herein, the cathode 50 disposed on the transparent substrate 100 may include a metal oxide-based transparent electrode (e.g., ITO), and the anode 10 facing the cathode may include a metal (e.g., having a relatively high work function, Au, Ag, etc.). For example, an (optionally doped) n-type metal oxide (crystalline Zn metal oxide) or the like may be disposed as an electron auxiliary layer 40 (e.g., an electron transport layer) between the transparent electrode 50 and the light emitting layer 30, a hole auxiliary layer 20 (e.g., a hole transport layer including TFB, PVK, or a combination thereof; a hole injection layer including MoOs or other p-type metal oxide; or a combination thereof) may be disposed between the metal anode 10 and the light emitting layer 30. (See FIG. 3.)

The aforementioned device may be manufactured by an appropriate method. For example, the electroluminescent device may be manufactured by optionally forming a hole auxiliary layer (e.g., by deposition or coating) on a substrate on which an electrode is disposed, forming a light emitting layer including nanostructures (e.g., a pattern of the aforementioned nanostructures), and forming (optionally, an electron auxiliary layer and) an electrode (e.g., by vapor deposition or coating) on the light emitting layer. A method of forming the electrode/hole auxiliary layer/electron auxiliary layer may be appropriately selected and is not particularly limited.

In an embodiment, each layer included in the hole transport region, the light-emitting layer, and each layer included in the electron transport region may be formed in a predetermined region using various methods such as vacuum deposition, spin coating, casting, Langmuir-Blodgett (LB) method, inkjet printing, laser printing, and Laser Induced Thermal Imaging (LITI). For example, the light-emitting layer may be formed by inkjet printing. The inkjet process is as described herein.

When each layer included in the hole transport region, the light-emitting layer, and each layer included in the electron transport region is formed by vacuum deposition, the deposition conditions may be appropriately selected. For example, the deposition temperature may be about 100°C to about 500°C, the vacuum degree may be about 10^-8 to about 10^-3 torr, and the deposition rate range may be about 0.01 to about 100 angstroms per second (Å/sec). The deposition conditions may be selected in consideration of the material to be included in the layer to be formed and the structure of the layer to be formed.

The electroluminescent device may be configured to emit blue light. The wavelength range of the blue light is as described herein. The electroluminescent device may be configured to emit green light. The wavelength range of the green light is as described herein. The electroluminescent device may be configured to emit red light. The wavelength range of the red light is as described herein.

In the electroluminescent device of an embodiment, a maximum external quantum efficiency ("EQE") may be greater than or equal to about 4%, greater than or equal to about 5%, greater than or equal to about 6%, greater than or equal to about 7%, greater than or equal to about 8%, greater than or equal to about 9%, greater than or equal to about 10%, greater than or equal to about 10.5%, greater than or equal to about 11%, greater than or equal to about 11.5%, greater than or equal to about 12%, greater than or equal to about 12.5%, greater than or equal to about 13%, greater than or equal to about 13.5%, or greater than or equal to about 14%. In the electroluminescent device of an embodiment, a maximum external quantum efficiency ('EQE") may be less than or equal to about 50%, less than or equal to about 40%, less than or equal to about 30%, or less than or equal to about 20%.

The electroluminescent device may have a maximum luminance of greater than or equal to about 40,000 nits (cd/m²), greater than or equal to about 50,000 nits, greater than or equal to about 60,000 nits, greater than or equal to about 70,000 nits, greater than or equal to about 80,000 nits, greater than or equal to about 90,000 nits, greater than or equal to about 95,000 nits, greater than or equal to about 100,000 nits, greater than or equal to about 105,000 nits, greater than or equal to about 110,000 nits, greater than or equal to about 115,000 nits, greater than or equal to about 120,000 nits, or greater than or equal to about 125,000 nits. The maximum luminance may be in the range of about 3,000 nits to about 500,000 nits.

The electroluminescent device may exhibit improved lifespan. In an embodiment, the lifespan of the electroluminescent device may be measured while driving at a predetermined initial luminance (e.g., 146 nits or 650 nits).

The lifespan T50 of the electroluminescent device may be greater than or equal to about 10 hours, greater than or equal to about 50 hours, greater than or equal to about 80 hours, greater than or equal to about 100 hours, greater than or equal to about 120 hours, greater than or equal to about 130 hours, greater than or equal to about 150 hours, greater than or equal to about 300 hours, greater than or equal to about 310 hours, greater than or equal to about 350 hours, greater than or equal to about 380 hours, greater than or equal to about 400 hours, greater than or equal to about 450 hours, greater than or equal to about 500 hours, greater than or equal to about 600 hours, greater than or equal to about 700 hours, greater than or equal to about 800 hours, greater than or equal to about 900 hours, greater than or equal to about 1,000 hours, greater than or equal to about 1,500 hours, or more.

The lifespan T90 of the electroluminescent device may be greater than or equal to about 10 hours, greater than or equal to about 15 hours, greater than or equal to about 20 hours, greater than or equal to about 25 hours, greater than or equal to about 30 hours, greater than or equal to about 35 hours, greater than or equal to about 40 hours, greater than or equal to about 50 hours, greater than or equal to about 75 hours, greater than or equal to about 100 hours, greater than or equal to about 125 hours, greater than or equal to about 150 hours, greater than or equal to about 175 hours, greater than or equal to about 200 hours, greater than or equal to about 300 hours, greater than or equal to about 310 hours, greater than or equal to about 350 hours, greater than or equal to about 380 hours, greater than or equal to about 400 hours, greater than or equal to about 450 hours, greater than or equal to about 500 hours, greater than or equal to about 600 hours, greater than or equal to about 700 hours, greater than or equal to about 800 hours, greater than or equal to about 900 hours, greater than or equal to about 1,000 hours, greater than or equal to about 1,500 hours, or more.

In an embodiment, T50 may be in the range of about 150 hours to about 5,000 hours, about 400 hours to about 4,000 hours, about 500 hours to about 3,500 hours, about 750 hours to about 2,000 hours, about 1,000 hours to about 1,500 hours, or a combination thereof.

In an embodiment, T90 may be in the range of about 13 hours to about 5,000 hours, about 15 hours to about 2,800 hours, about 18 hours to about 1,200 hours, about 22 hours to about 1,000 hours, about 31 hours to about 800 hours, about 50 hours to about 700 hours, about 60 hours to about 500 hours, about 80 hours to about 400 hours, or a combination thereof.

In an embodiment, a display device includes the electroluminescent device described herein.

The display device may include a first pixel and a second pixel that is configured to emit light different from the light of the first pixel.

The display device (e.g., a display panel) may include a first pixel and a second pixel configured to emit light of a color different from that of the first pixel. In one embodiment, the first light emitted from the light-emitting layer may be extracted through the second electrode (e.g., in the Z direction) (see Fig. 4 or Fig. 5). In an embodiment, the first light may be extracted through the (transparent) first electrode and optionally through the substrate 100 (see Fig. 3). The light-emitting layer may be disposed within a pixel (or subpixel) in the display device (display panel) as described below (see Fig. 4 or Fig. 5).

Referring to FIG. 6, a display panel 1000 according to an embodiment may include a display area 1000D for displaying an image and a non-display area 1000P disposed around the display area 1000D, in which the binding element may be located.

The display area 1000D may include a plurality of pixels PXs arranged along a row (e.g., x direction) and/or a column (e.g., y direction), and each pixel PX may include a plurality of sub-pixels PX₁, PX₂, and PX₃ displaying different colors. As an example, a configuration in which three sub-pixels PX₁, PX₂, and PX₃ constitute one pixel PX is illustrated, but the configuration is not limited thereto. An additional sub-pixel such as a white sub-pixel may be further included, and one or more sub-pixel displaying the same color may be included. The plurality of pixels PXs may be arranged in, for example, a Bayer matrix, a PenTile matrix, and/or a diamond matrix, but is not limited thereto.

Each of the sub-pixels PX₁, PX₂, and PX₃ may be configured to display a color of three primary colors or a combination of three primary colors, for example, red, green, blue, or a combination thereof (e.g., white light). For example, the first sub-pixel PX₁ may be configured to display red, the second sub-pixel PX₂ may be configured to display green, and the third sub-pixel PX₃ may be configured to display blue.

In the figure, each of the sub-pixels are depicted to have the same size, but the present disclosure is not limited thereto. For example, at least one of the sub-pixels may be larger or smaller, or have a different shape, than another sub-pixel.

In an embodiment, the display panel of an embodiment may include a light emitting panel which may include a lower substrate 110, a buffer layer 111, a thin film transistor TFT, and a light emitting element 180. The display panel may further include a circuit element for switching and/or driving each of the light emitting elements.

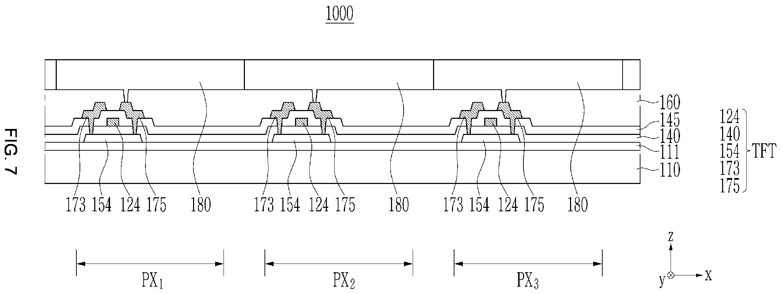

Referring to FIG. 7, in the light emitting panel of an embodiment, the light emitting element 180 may be disposed for each sub-pixel PX₁, PX₂, and PX₃. The light emitting element 180 disposed in each sub-pixel PX₁, PX₂, and PX₃ may be independently driven. The subpixel may include a blue subpixel, red subpixel, or a green subpixel. At least one of the light emitting element 180 may be an electroluminescent element according to an embodiment described herein.

Details of the substrate are the same as described herein. The buffer layer 111 may include an organic material, an inorganic material, or an organic-inorganic material. The buffer layer 111 may include, for example, an oxide, a nitride, or an oxynitride, and may include, for example, silicon oxide, silicon nitride, silicon oxynitride, or a combination thereof, but is not limited thereto. The buffer layer 111 may be one layer or two or more layers and may cover a portion of or the entire surface of the lower substrate 110. The buffer layer 111 may be omitted.

The thin film transistor TFT may be a three terminal element for switching and/or driving the light emitting element 180, and one or two or more may be included for each sub-pixel. The thin film transistor TFT may include a gate electrode 124, a semiconductor layer 154 overlapped with the gate electrode 124, a gate insulating layer 140 between the gate electrode 124 and the semiconductor layer 154, and a source electrode 173 and a drain electrode 175 electrically connected to the semiconductor layer 154. A coplanar top gate structure is shown as an example, but the structure is not limited thereto and may have various structures.

The gate electrode 124 is electrically connected to a gate line (not shown), and may include, for example, a low-resistance metal such as aluminum (Al), molybdenum (Mo), copper (Cu), titanium (Ti), silver (Ag), gold (Au), an alloy thereof, or a combination thereof, but is not limited thereto.

The semiconductor layer 154 may be an inorganic semiconductor such as amorphous silicon, polycrystalline silicon, or oxide semiconductor; an organic semiconductor; an organic-inorganic semiconductor; or a combination thereof. For example, the semiconductor layer 154 may include an oxide semiconductor including at least one of indium (In), zinc (Zn), tin (Sn), and gallium (Ga), and the oxide semiconductor may include, for example, indium-gallium-zinc oxide, zinc-tin oxide, or a combination thereof, but they are not limited thereto. The semiconductor layer 154 may include a channel region and doped regions disposed on both sides of the channel region and electrically connected to the source electrode 173 and the drain electrode 175, respectively.

The gate insulating layer 140 may include an organic material, an inorganic material, or an organic-inorganic material, and may include, for example, an oxide, a nitride, or an oxynitride, and may include, for example, silicon oxide, silicon nitride, silicon oxynitride, or a combination thereof, but is not limited thereto. In the drawing, an example in which the gate insulating layer 140 is formed on the entire surface of the lower substrate 110 is illustrated, but the present disclosure is not limited thereto and may be selectively formed between the gate electrode 124 and the semiconductor layer 154. The gate insulating layer 140 may be formed of one or two or more layers.

The source electrode 173 and the drain electrode 175 may include, for example, a low-resistance metal such as aluminum (Al), molybdenum (Mo), copper (Cu), titanium (Ti), silver (Ag), gold (Au), an alloy thereof, or a combination thereof, but are not limited thereto. The source electrode 173 and the drain electrode 175 may be electrically connected to the doped regions of the semiconductor layer 154, respectively. The source electrode 173 may be electrically connected to a data line (not shown), and the drain electrode 175 is electrically connected to a light emitting element 180.

An interlayer insulating layer 145 may be additionally formed between the gate electrode 124 and the source/drain electrodes 173 and 175. The interlayer insulating layer 145 may include an organic material, an inorganic material, or an organic-inorganic material, for example, oxide, nitride, or oxynitride, for example, silicon oxide, silicon nitride, silicon oxynitride, or a combination thereof, but is not limited thereto. The interlayer insulating layer 145 may be formed of one or two or more layers.

A protective layer 160 may be formed on the thin film transistor TFT. The protective layer 160 may be, for example, a passivation layer. The protective layer 160 may include an organic material, an inorganic material, or an organic-inorganic material, for example, polyacrylic, polyimide, polyamide, poly(amide-imide), or a combination thereof, but is not limited thereto. The protective layer 160 may be formed of one or two or three or more layers.

In an embodiment, one of the first electrode 1, 10 and the second electrode 5, 50, may be a pixel electrode linked to the TFT and the other of them may be a common electrode.

In an embodiment, the light emitting device or the display device including the same may be used in a top emission type, a bottom emission type, a dual emission type, or a combination thereof.

In an embodiment, the first electrode 1, 10 may be a light transmitting electrode and the second electrode 5, 50 may be a reflective electrode, and the display panel may be a bottom emission type display panel that emits light toward the first electrode 10 and the lower substrate 110, if present. In an embodiment, the first electrode 1, 10 may be a reflective electrode and the second electrode 5, 50 may be a light transmitting electrode, and the display panel may be a top emission type display panel that emits light to the opposite side of the first electrode 10 and the lower substrate 110 if present. In an embodiment, both the first electrode and the second electrode may be translucent electrodes, and the display panel 1000 may be a both side emission type display panel that emits light on the substrate side and on the opposite side of the substrate.

The display device or an electronic apparatus may include (or may be) a device or apparatus such as a television, a virtual reality/augmented reality (VR/AR), a handheld terminal, a monitor, a notebook computer, an electronic display board, a camera, or a part for an automatic, e.g., autonomous, vehicle.

Specific examples are described below. However, the examples described below are only for specifically illustrating or explaining the disclosure, and the scope of the disclosure is not limited thereto.

### Examples

### 1. Photoluminescence (PL) Analysis and TRPL Analysis

The photoluminescence spectrum and absolute QY of the nanoparticles were obtained at room temperature with an excitation wavelength of 372 nm using a Hitachi F-7000 spectrophotometer or a Hamamatsu QY instrument (Quantaurus-QY Absolute PL quantum yield spectrophotometer C11347-11).

### 2. GC Analysis

Gas chromatography analysis was performed using an Agilent GC-MS 7890B/5977A. No standard substances were used. After separating the crude containing the manufactured semiconductor nanoparticles twice with ethanol (EtOH) and vacuum drying, 0.1 mg of the manufactured semiconductor nanoparticles + 1 microliter (µL) of TMAH (tetramethylammonium hydroxide) were mixed and left in the hood for 2 minutes before performing py-GC/MS measurement.
Pyrolyzer: 450°C
Column: 30m X 0.25mm X 0.25 mm (UA5)
Flow: He (1 mL/min)
Inlet temperature: 300°C
Oven temperature: 50°C (held for 2 min), increases up to 320°C at 20°C/min (held for 10 min)
Analyzer: quadrupole (range: 10 to 550 m/z)

### 3. TGA

A thermogravimetric analysis was performed using a Trios V3.2 system (TA Instruments) under nitrogen gas at a heating rate of 10°C/min from 20°C to 600°C. The weight loss from 200°C to 550°C was measured as the organic content.

### 4. Electroluminescence Measurement

A current according to an applied voltage is measured with a Keithley 2635B source meter, and a CS2000 spectrometer is used to measure electroluminescent properties (e.g., luminance and EQE) of a light-emitting device.

### 5. Lifespan

T90(h): The time (hours) it takes for the luminance to reach 90% of the initial luminance when driven at a predetermined luminance (e.g., 650 nits or 146 nits) was measured.

T50(h): The time (hours) it takes for the luminance to reach 50% of the initial luminance when driven at a predetermined luminance (e.g., 650 nits or 146 nits) was measured.

The following synthesis is performed under an inert gas atmosphere (e.g., under nitrogen) unless otherwise specified. A precursor content is provided as a molar content, unless otherwise specified.

### Reference Example 1: Preparation of Particle Containing First Semiconductor Nanocrystal and Second Semiconductor Nanocrystal

Selenium (Se), sulfur (S), and tellurium (Te) were dispersed in trioctylphosphine (TOP) to obtain a 2 molar (M) SeΓΓOP stock solution, a 1M S/TOP stock solution, and a 0.1M Te/TOP stock solution.

In a 300 milliliter (mL) reaction flask containing trioctylamine, 4.5 millimole (mmol) of zinc acetate was added with oleic acid and heated to 120°C under vacuum. After 1 hour, the atmosphere in the reactor was switched to an inert gas.

After heating to 240°C to 300°C, the prepared SeΓΓOP stock solution and Te/TOP stock solution were quickly injected at a Te/Se ratio of 1/15. The reaction was carried out for 40 minutes. After the reaction was completed, ethanol was added to the reaction solution, which was quickly cooled to room temperature, and centrifuged to obtain ZnTeSe semiconductor nanocrystals. The obtained precipitate was dispersed in hexane to obtain ZnSeTe cores. An average size of the cores was approximately 3 nm.

In a 300 mL reaction flask containing TOA, zinc acetate was added with oleic acid and vacuum-treated at 120°C. The nitrogen (N₂) was flowed into the flask, and then the flask was heated to the reaction temperature (340°C). The hexane dispersion of the ZnSeTe cores was quickly added to the reaction flask, followed by the addition of the SeΓΓOP stock solution to proceed with the reaction. Regarding the formation of the ZnSe shell, the amount of selenium precursor relative to 1 mole of the zinc precursor was 0.67 moles.

After the reaction was completed, the reactor was cooled to room temperature, and ethanol was added to the reaction solution to precipitate nanoparticles containing the first semiconductor nanocrystal (ZnTeSe) and the second semiconductor nanocrystal (ZnSe). The precipitate was recovered by centrifugation, and it was confirmed that the obtained nanoparticles could be dispersed in hydrocarbon solvents such as octane.

### Reference Example 2: Synthesis of ZnMgO Nanoparticles

Zinc acetate dihydrate and magnesium acetate tetrahydrate are added to a reactor containing dimethylsulfoxide and heated at 60 °C in air. Subsequently, an ethanol solution of tetramethylammonium hydroxide pentahydrate is added to the reactor. After stirring the mixture for 1 hour, a precipitate form and is separated from the reaction mixture with a centrifuge. The precipitate is dispersed in ethanol to obtain Zn₁₋ₓMgₓO nanoparticles. (x = 0.15) The obtained nanoparticles are subjected to a transmission electron microscope analysis. The particles have an average size of about 3 nm.

### Preparation Example 1:

In trioctylamine, zinc acetate and ethyl butyric acid (CAS No. 88-09-5, Sigma-Aldrich) of the following structure were each added (at a mole ratio between zinc acetate and ethyl butyric acid of 1:2) and heated to 120°C under vacuum for 1 hour to prepare the first zinc precursor:

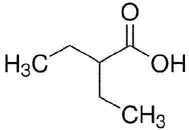

In trioctylamine, zinc acetate and oleic acid of the following structure were each added (at a mole ratio between zinc acetate and oleic acid of 1:2) and heated to 120°C under vacuum for 1 hour to prepare the second zinc precursor:

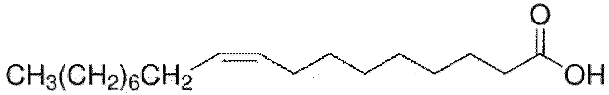

Trioctylamine was added to a 300 mL reaction flask and heated to 120°C under vacuum for 1 hour, and the nitrogen (N₂) was flowed into the flask. While raising the flask temperature to the reaction temperature (340°C), the octane dispersion of the particles prepared in the reference example was added, followed by the first zinc precursor and dodecanethiol (sulfur precursor) each injected in two portions.

After 30 minutes, while adjusting the reaction temperature to 250°C to 300°C, zinc chloride and the second zinc precursor were added. The total reaction time was 70 minutes.

The molar ratio of the first zinc precursor, the second zinc precursor, and the sulfur precursor (first zinc precursor: second zinc precursor: sulfur precursor) was 2.1:0.4:1.4.

The molar ratio of the total zinc precursor to zinc chloride used was 2.5:0.4.

The reactor was cooled to room temperature, and ethanol was added to the reaction solution to promote precipitation of the semiconductor nanoparticles, which were recovered by centrifugation. The obtained semiconductor nanoparticles were dispersed in octane. Photoluminescence spectroscopy and a TGA were performed on the obtained semiconductor nanoparticles, and the results were summarized in Table 1.

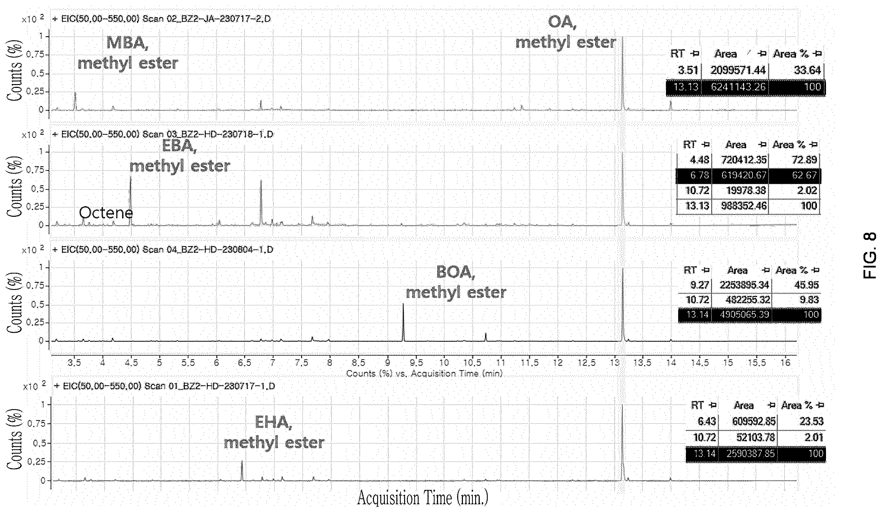

A GC analysis was performed on the obtained semiconductor nanoparticles, and the results were summarized in FIG. 8. According to the results of FIG. 8, the first peak assigned to the ethyl butyrate ester moiety at a retention time (i.e., acquisition time) of 6.78 minutes and the second peak assigned to the oleate ester moiety at a retention time of 13.13 minutes were each confirmed, and the area percentage of the first peak relative to the area of the second peak (100%) was confirmed to be 62.57%.

### Preparation Example 2:

Except for using ethyl hexanoic acid (CAS No. 149-57-5, Sigma-Aldrich) of the following structure instead of ethyl butyric acid, semiconductor nanoparticles were prepared in the same manner as in Preparation Example 1:

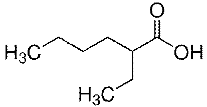

The reactor was cooled to room temperature, and ethanol was added to the reaction solution to promote precipitation of the semiconductor nanoparticles, which were recovered by centrifugation. The obtained semiconductor nanoparticles were dispersed in octane. Photoluminescence spectroscopy and TGA were performed on the obtained semiconductor nanoparticles, and the results were summarized in Table 1. A GC analysis was performed on the obtained semiconductor nanoparticles, and the results were summarized in FIG. 8. According to the results of FIG. 8, the first peak assigned to the ethyl hexanoate ester moiety at a retention time of 6.43 minutes and the second peak assigned to the oleate ester moiety at a retention time of 13.14 minutes were each confirmed, and the area percentage of the first peak relative to the area of the second peak (100%) was confirmed to be 23.53%.

### Preparation Example 3:

Except for using propylvaleric acid (CAS No. 99-66-1, Sigma-Aldrich) of the following structure instead of ethyl butyric acid, semiconductor nanoparticles were prepared in the same manner as in Preparation Example 1:

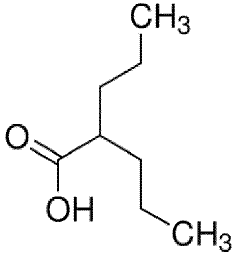

The reactor was cooled to room temperature, and ethanol was added to the reaction solution to promote precipitation of the semiconductor nanoparticles, which were recovered by centrifugation. The obtained semiconductor nanoparticles were dispersed in octane. Photoluminescence spectroscopy and TGA were performed on the obtained semiconductor nanoparticles, and the results were summarized in Table 1.

### Preparation Example 4:

Except for using both ethyl butyric acid and ethyl hexanoic acid to prepare the first zinc precursor, semiconductor nanoparticles were prepared in the same manner as in Preparation Example 1.

The reactor was cooled to room temperature, and ethanol was added to the reaction solution to promote precipitation of the semiconductor nanoparticles, which were recovered by centrifugation. The obtained semiconductor nanoparticles were dispersed in octane. Photoluminescence spectroscopy and TGA were performed on the obtained semiconductor nanoparticles, and the results were summarized in Table 1. GC analysis was performed on the obtained semiconductor nanoparticles, and according to the results, the first peaks assigned to the ethyl butyrate ester moiety (EBA assigned peak retention time 4.42 minutes) and the ethyl hexanoate ester moiety (EHA assigned peak retention time 6.36 minutes) and the second peak assigned to the oleate ester moiety (retention time 13.07 minutes) were confirmed. The area percentage of the first peaks (EBA area percentage 10.7% + EHA area percentage 32.82%) relative to the area of the second peak (100%) was confirmed to be 43.52%.

### Preparation Example 5:

Except for tripling the amount of zinc chloride used, semiconductor nanoparticles were prepared in the same manner as in Preparation Example 1.

The reactor was cooled to room temperature, and ethanol was added to the reaction solution to promote precipitation of the semiconductor nanoparticles, which were recovered by centrifugation. The obtained semiconductor nanoparticles were dispersed in octane. It was confirmed that the dispersion of the obtained semiconductor nanoparticles could form a colloidal dispersion. TGA was performed on the obtained semiconductor nanoparticles. As a result, it was confirmed that the organic content was 7.7 wt% and the residue content at 550°C was approximately 91.37 wt%.

According to the GC analysis of the obtained semiconductor nanoparticles, the first peak assigned to the ethyl hexanoate ester moiety at a retention time of 6.42 minutes and the second peak assigned to the oleate ester moiety at a retention time of 13.1 minutes were each confirmed, and the area percentage of the first peak relative to the area of the second peak (100%) was confirmed to be 130%.

### Preparation Example 6:

Except for using methyl butyric acid (CAS No. 116-53-0, Sigma-Aldrich) of the following structure instead of ethyl butyric acid, semiconductor nanoparticles were prepared in the same manner as in Preparation Example 1:

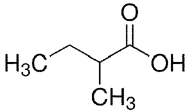

The reactor was cooled to room temperature, and ethanol was added to the reaction solution to promote precipitation of the semiconductor nanoparticles, which were recovered by centrifugation. The obtained semiconductor nanoparticles were dispersed in octane. GC analysis was performed on the obtained semiconductor nanoparticles, and the results were summarized in FIG. 8. According to the results of FIG. 8, the first peak assigned to the methyl butyrate ester moiety at a retention time of 3.51 minutes and the second peak assigned to the oleate ester moiety at a retention time of 13.13 minutes were each confirmed, and the area percentage of the first peak relative to the area of the second peak (100%) was confirmed to be 33.64%.

TGA was performed on the obtained semiconductor nanoparticles. As a result, it was confirmed that the organic content was 10.53 wt% and the residue content at 550°C was 87.88 wt%.

### Preparation Example 7:

Except for using 2-butyloctanoic acid (CAS No. 27610-92-0, Sigma-Aldrich) of the following structure instead of ethyl butyric acid, semiconductor nanoparticles were prepared in the same manner as in Preparation Example 1:

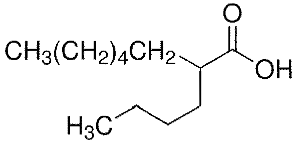

The reactor was cooled to room temperature, and ethanol was added to the reaction solution to promote precipitation of the semiconductor nanoparticles, which were recovered by centrifugation. The obtained semiconductor nanoparticles were dispersed in octane. GC analysis was performed on the obtained semiconductor nanoparticles, and the results were summarized in FIG. 8. According to the results of FIG. 8, the first peak assigned to the 2-butyloctanoic acid ester moiety at a retention time of 9.27 minutes and the second peak assigned to the oleate ester moiety at a retention time of 13.14 minutes were each confirmed, and the area percentage of the first peak relative to the area of the second peak (100%) was confirmed to be 45.95%.

TGA was performed on the obtained semiconductor nanoparticles. As a result, it was confirmed that the organic content was approximately 11.1 wt% and the residue content at 550°C was approximately 88 wt%.

### Comparative Preparation Example 1

Except for using only the second zinc precursor without using the first zinc precursor, semiconductor nanoparticles were prepared in the same manner as in Preparation Example 1.

The reactor was cooled to room temperature, and ethanol was added to the reaction solution to promote precipitation of the semiconductor nanoparticles, which were recovered by centrifugation. The obtained semiconductor nanoparticles were dispersed in octane. Photoluminescence spectroscopy and TGA were performed on the obtained semiconductor nanoparticles, and the results were summarized in Table 1.

A GC analysis was performed on the obtained semiconductor nanoparticles. According to the results, the second peak assigned to the oleate ester moiety at a retention time of 13.14 minutes was confirmed, but no peak corresponding to the first peak was substantially observed.

**Table 1**

| | PWL(nm) | FWHM(nm) | Absolute QY (%) | Organic Content (wt%) | Residue content at 550°C (wt%) |
|---|---|---|---|---|---|
| Preparation Example 1 (EBA) | 464 | 42 | 92 | 10.3 | 88.83 |
| Preparation Example 2 (EHA) | 462 | 42 | 90 | 10.5 | 88.54 |
| Preparation Example 3 (PVA) | 460 | 41 | 95 | 11.5 | 87.34 |
| Preparation Example 4 (EHA+EBA) | 464 | 40 | 92 | 10.6 | 88.35 |
| Comp. Preparation | 466 | 43 | 91 | 13.5 | Less than 87 |
| Example 1 | | | | | |

| | | | | | |
|---|---|---|---|---|---|
| PWL: Emission Peak Wavelength FWHM: Full Width at Half Maximum Absolute QY: Absolute Quantum Yield | | | | | |

### Device Example

### Example 1

Using the semiconductor nanoparticles prepared in Preparation Example 1, an electroluminescent device with the structure ITO/PEDOT:PSS (300 Å)/TFB (250 Å)/semiconductor nanoparticle emitting layer (360 Å)/ZnMgO (240 Å)/Al was fabricated, and the electroluminescent properties were measured as follows:
On a glass substrate with an ITO electrode (first electrode) deposited, PEDOT:PSS and TFB layers were formed as a hole injection layer and a hole transport layer by spin coating. The semiconductor nanoparticle solution prepared in Preparation Example 1 was spin-coated on the formed TFB layer (25 nm) to form the emitting layer. On the emitting layer, a zinc magnesium oxide nanoparticle layer was formed as the electron auxiliary layer, and then an Al electrode was deposited to fabricate the electroluminescent device.

The electroluminescent properties and lifespan of the fabricated device were measured. The electroluminescent properties are summarized in Table 2.

### Example 2

Except for using the semiconductor nanoparticles prepared in Preparation Example 2, the electroluminescent device was fabricated in the same manner as in Example 1. The electroluminescent properties and lifespan of the fabricated device were measured. The electroluminescent properties are summarized in Table 2.

### Example 3

Except for using the semiconductor nanoparticles prepared in Preparation Example 3, the electroluminescent device was fabricated in the same manner as in Example 1. The lifespan of the fabricated device was measured, and the results are summarized in Table 3.

### Example 4

Except for using the semiconductor nanoparticles prepared in Preparation Example 4, the electroluminescent device was fabricated in the same manner as in Example 1. The lifespan of the fabricated device was measured, and the results are summarized in Table 3.

### Example 5

Except for using the semiconductor nanoparticles prepared in Preparation Example 5, the electroluminescent device was fabricated in the same manner as in Example 1. The lifespan of the fabricated device was measured, and the results are summarized in Table 3. It was confirmed that the fabricated device had a T90 @146 nits of more than 1,000 hours.

### Comparative Example 1

Except for using the semiconductor nanoparticles prepared in Comparative Preparation Example 1, the electroluminescent device was fabricated in the same manner as in Example 1. The electroluminescent properties and lifespan of the fabricated device were measured, and the results are summarized in Table 2, Table 3, and Table 4.

**Table 2**

| | EQE Max (%) | Lum Max (nit) | T90 @650nit | T50 @650nit |
|---|---|---|---|---|
| Comp. Example 1 | 11.1 | 107879 | 47 | 189 |
| Example 1 | 11.8 | 123176 | 73 | 316 |
| Example 2 | 11.7 | 113195 | 85 | 333 |

| | | | | |
|---|---|---|---|---|
| EQE Max: Maximum External Quantum Efficiency Lum Max: Maximum Luminance T90 @650nit: T90 (hours) when driven at an initial luminance of 650 nits T50 @650nit: T50 (hours) when driven at an initial luminance of 650 nits | | | | |

From the results in Table 2, it was confirmed that the electroluminescent devices of the examples may have improved electroluminescent properties and extended lifespan compared to the device of the comparative example.

**Table 3**

| | Relative T90 @650nit |
|---|---|
| Comp. Example 1 | 100% |
| Example 3 | 162% |
| Example 4 | 300% |

Relative T90 @650nit: The T90 (hours) of a given device at 650 nits relative to the T90 (hours) of Comparative Example 1 at 650 nits

**Table 4**

| | Relative T90 @146nit |
|---|---|
| Comp. Example 1 | 100% |
| Example 5 | 335% |

Relative T90 @146nit: The T90 (hours) of a given device at 146 nits relative to the T90 (hours) of Comparative Example 1 at 146 nits

From the results in Table 3 and Table 4, it was confirmed that the electroluminescent devices of the examples may have an extended lifespan compared to the device of the comparative example.

While this disclosure has been described in connection with what is presently considered to be practical example embodiments, it is to be understood that the invention is not limited to the disclosed embodiments, but, on the contrary, is intended to cover various modifications and equivalent arrangements included within the scope of the appended claims.

## Claims

1. A semiconductor nanoparticle, comprising:
zinc, selenium, and sulfur, and wherein the semiconductor nanoparticle does not comprise cadmium;
wherein the semiconductor nanoparticle comprises a first semiconductor nanocrystal and a semiconductor nanocrystal shell including zinc and sulfur disposed on the first semiconductor nanocrystal;
wherein the semiconductor nanoparticle further comprises a plurality of organic ligands comprising a first organic ligand having a carboxylate moiety and a second organic ligand different from the first organic ligand and having a carboxylate moiety;
wherein in a gas chromatography analysis, the semiconductor nanoparticle exhibits a first peak assigned to the first organic ligand and a second peak assigned to the second organic ligand; and
wherein an area percentage of the first peak relative to the second peak is greater than or equal to 1% and less than or equal to 300%.

2. The semiconductor nanoparticle of claim 1, wherein a ratio of a retention time of the first peak to a retention time of the second peak in the gas chromatography analysis of the semiconductor nanoparticle is greater than or equal to 0.1:1 and less than 1:1; and/or
wherein a total number of carbon atoms in the plurality of organic ligands is greater than or equal to about 20 and less than or equal to about 34.

3. The semiconductor nanoparticle of claim 1 or 2, wherein the area percentage of the first peak relative to the second peak is greater than or equal to 10% and less than or equal to 140%.

4. The semiconductor nanoparticle of any preceding claim, wherein the semiconductor nanoparticle further comprises chlorine, preferably wherein in the semiconductor nanoparticle, a molar ratio of chlorine to zinc is greater than or equal to about 0.01 and less than or equal to about 1; and/or
wherein the semiconductor nanoparticle comprises a Group II-VI compound, a Group III-V compound, a Group IV-VI compound, a Group IV element or compound, a Group II-III-VI compound, a Group I-III-VI compound, a Group I-II-IV-VI compound, or a combination thereof.

5. The semiconductor nanoparticle of any preceding claim, wherein the first semiconductor nanocrystal comprises an indium phosphide, an indium zinc phosphide, a zinc selenide, a zinc telluride, a zinc tellurium selenide, a silver indium gallium sulfide, a silver indium sulfide, or a combination thereof, and
wherein the semiconductor nanocrystal shell comprises a zinc selenide, a zinc selenide telluride, a zinc selenide sulfide, a zinc sulfide, or a combination thereof; and/or.

6. The semiconductor nanoparticle of any preceding claim, wherein the first organic ligand has a molecular weight of greater than or equal to 90 grams per mole and less than or equal to 260 grams per mole,
wherein the second organic ligand has a molecular weight of greater than or equal to 200 grams per mole and less than or equal to 500 grams per mole.

7. The semiconductor nanoparticle of any preceding claim, wherein the first organic ligand comprises a hexanoate moiety substituted with a C1-C3 alkyl group, a butanoate moiety substituted with a C1-C3 alkyl group, a pentanoate moiety substituted with a C1-C3 alkyl group, an octanoate moiety substituted with a C1-C4 alkyl group, or a combination thereof, and
wherein the second organic ligand comprises an aliphatic hydrocarbon group having greater than or equal to 17 carbon atoms.

8. The semiconductor nanoparticle of any preceding claim, wherein the first organic ligand comprises an ethyl butyrate moiety, a 2-ethyl hexanoate moiety, a propylvalerate moiety, a methyl butyrate moiety, a butyloctanoate moeity, or a combination thereof, and
wherein the second organic ligand comprises an oleate moiety.

9. The semiconductor nanoparticle of any preceding claim, wherein in a thermogravimetric analysis, the semiconductor nanoparticle has a weight loss in the range of 200°C to 550°C that is greater than or equal to 3% and less than or equal to 13% of a total weight of the semiconductor nanoparticle, or
wherein, in thermogravimetric analysis, the semiconductor nanoparticle has a residue content at 550°C that is greater than or equal to 87% of the total weight of the semiconductor nanoparticle.

10. An electroluminescent device comprising a first electrode and a second electrode spaced apart from each other, and a light-emitting layer disposed between the first electrode and the second electrode, wherein the light-emitting layer comprises the semiconductor nanoparticle of any preceding claim.

11. A method for producing the semiconductor nanoparticle of any preceding claim, wherein the method comprises:
mixing a zinc precursor with a sulfur precursor in a reaction medium containing an organic solvent and, optionally, an organic ligand, in the presence of a particle comprising a first semiconductor nanocrystal and, optionally, a second semiconductor nanocrystal; and
adding a metal halide to the reaction medium, wherein the zinc precursor comprises a first zinc precursor including the first organic ligand and a zinc ion and a second zinc precursor including the second organic ligand and a zinc ion.

12. The method of claim 11, wherein the first zinc precursor is a reaction product between a first carboxylic acid compound including the first organic ligand and a zinc compound, and the second zinc precursor is a reaction product between a second carboxylic acid compound including the second organic ligand and a zinc compound, wherein the first carboxylic acid compound has an acid dissociation constant of greater than or equal to 4.7 and less than or equal to 9, and the second carboxylic acid compound has an acid dissociation constant of greater than or equal to 9.2 and less than or equal to 10.2.

13. The method of claim 11 or 12, wherein the metal halide is added to the reaction medium after the first zinc precursor or the second zinc precursor is mixed with the sulfur precursor.

14. The method of any of claims 11 to 13, wherein an amount of the second zinc precursor is greater than or equal to 0.1 moles and less than or equal to 10 moles, per one mole of the first zinc precursor.

15. The method of any of claims 11 to 14, wherein an amount of the metal halide is greater than or equal to 0.05 moles and less than or equal to 0.9 moles, per one mole of the zinc precursor.
